# EUROPEAN PATENT APPLICATION

(11) **EP 2 530 103 A1**
(43) Date of publication of application: **05.12.2012**
(21) Application number: 11734529.8
(22) Date of filing: 24.01.2011
(51) Int. Cl.: C08G 73/10, B32B 9/00, C08K 3/00, C08L 79/08, C09J 179/08, H01L 23/14, H05K 1/03

(54) **POLYIMIDE RESIN COMPOSITION, ADHESIVE AGENT AND LAMINATE EACH COMPRISING SAME, AND DEVICE**

(30) Priority: 24.09.2010 JP 2010213806; 01.07.2010 JP 2010151165; 25.01.2010 JP 2010013201
(71) Applicant: Mitsui Chemicals, Inc., Tokyo 105-7117 (JP)
(72) Inventor: IIDA, Kenji, Chiba 299-0265 (JP); IMAGAWA, Kiyomi, Chiba 299-0265 (JP); TOMITA, Yusuke, Chiba 299-0265 (JP)
(74) Representative: HOFFMANN EITLE
(86) International application number: PCT/JP2011/000357
(87) International publication number: WO 2011/089922

(57) **Abstract**

Provided are a polyimide resin composition containing a polyimide obtained by the condensation of: a diamine component containing an aromatic diamine (A) represented by the general formula (1-1) or the like, a silicone diamine (B) represented by the general formula (2) and an aliphatic diamine (C) represented by the general formula (3); and an acid anhydride component containing a specific aromatic tetracarboxylic dianhydride (D); and a laminate and a device using the polyimide resin composition.

## Description

### TECHNICAL FIELD

The present invention relates to a polyimide resin composition, and adhesive agent, a laminate, and a device each including the polyimide resin composition.

### BACKGROUND ART

Conventionally, polyamide-imide-based and polyamide-based hot-melt adhesive agents (see Patent Document 1), polyimide-based adhesive agents (see Patent Document 2), and thermosetting polyimide-based adhesive agents (see Patent Documents 3 and 4) have been proposed as heat-resistance adhesive agents which are capable of thermocompression bonding. However, the adhesive agents in Patent Document 1 have highly hydrophilic amide groups, and have a high water absorption coefficient, which are thus not appropriate as adhesive agents for electronics applications requiring reliability. In addition, the adhesive agents in Patent Documents 2 to 4 are not appropriate for electronic components sensitive to heat or pressure, or for applications requiring mass productivity, because of standard conditions for thermocompression bonding: 275°C; 50 kgf/cm²; and 30 minutes.

On the other hand, adhesive agents such as epoxy types, phenol types, and acrylic types have the advantage of being capable of thermocompression bonding at relatively low temperature and low pressure. However, these thermosetting adhesive agents thus not only require a long period of time for curing, but also have insufficient heat resistance.

For these reasons, polyimide-based adhesive agents have been studied which have no need to be thermally cured for use as an adhesive agent, and have excellent heat resistance. However, the polyimide-based adhesive agents have the problem of low adhesion to inorganic base materials such as silicon, ceramics, and metals.

In contrast, it has been proposed that the adhesion is increased by lowering the glass transition temperature of polyimide through the introduction of a long-chain aliphatic skeleton or silicone skeleton in a polyimide skeleton (for example, see Patent Documents 5 and 6).

### Prior Art Documents

### Patent Documents

Patent Document 1: JP-A-1-282283
Patent Document 2: JP-A-1-58-157190
Patent Document 3: JP-A-1-62-235382
Patent Document 4: JP-A-1-62-235383
Patent Document 5: JP-A-1-5-125337
Patent Document 6: JP-A-1-2004-176046

### DISCLOSURE OF THE INVENTION

### PROBLEMS TO BE SOLVED BY THE INVENTION

The polyimide with a large amount of aliphatic skeleton introduced has a low glass transition temperature, and also has rubber-like elasticity, and the adhesion is thus improved to some extent. However, the heatproof temperature (thermal decomposition temperature) is lowered, and the polyimide is thus not appropriate as, in particular, an adhesive agent for a device with high heat generation, such as a power device. In addition, the polyimide with a large amount of silicone skeleton introduced may be not only generally expensive but also cause defective contact, or the like due to the volatilization of cyclic siloxane. Therefore, the polyimide with a large amount of silicone skeleton introduced is also not appropriate as an adhesive agent for a device.

The present invention has been achieved in view of the circumstances, and an object of the present invention is to provide a polyimide resin composition that can achieve a balance between high heat resistance and excellent low-temperature adhesion, as well as an adhesive agent, a laminate, and a device including the polyimide resin composition.

### SOLUTIONS TO THE PROBLEMS

Aromatic polyimides obtained from aromatic diamines and aromatic tetracarboxylic dianhydrides generally have high heat resistance, but low adhesion. Thus, the low-temperature adhesion can be increased by introducing, into an aromatic polyimide, a skeleton derived from a silicone diamine. However, the skeleton derived from a silicone diamine undergoes the volatilization of cyclic siloxane due to thermal decomposition or the like, or the volatilization of the unpolymerized silicone diamine, thus can be introduced only in not more than a certain amount, and it is difficult to achieve desired low-temperature adhesion only with the certain amount of skeleton. Therefore, as a result of intensive studies, the inventors have found that a balance between excellent low-temperature adhesion and heat resistance can be achieved by further introducing a skeleton derived from an aliphatic diamine in addition to a skeleton derived from a silicone diamine. Furthermore, the inventors have found that an inventive method for introducing the skeleton derived from a silicone diamine can reduce the volatilization of cyclic siloxane or unpolymerized silicone diamine to enhance the heat resistance. The present invention has been achieved on the basis of this fmding.

A first aspect of the present invention relates to a polyimide resin composition and an adhesive agent including the polyimide resin composition.
[1] A polyimide resin composition including a polyimide obtained by condensation of: a diamine component containing an aromatic diamine (A) represented by any of the following general formula (1-1) to (1-3), a silicone diamine (B) represented by the following general formula (2) and an aliphatic diamine (C) represented by the following general formula (3); and an acid anhydride component containing an aromatic tetracarboxylic dianhydride (D) represented by the following general formula (4). 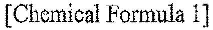 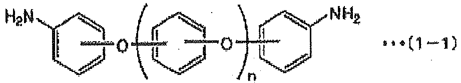 (In the general formula (1-1), n represents an integer of 1 to 20.) 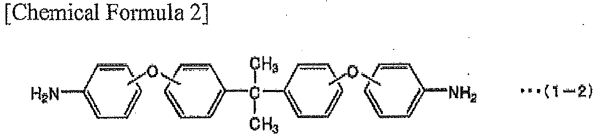 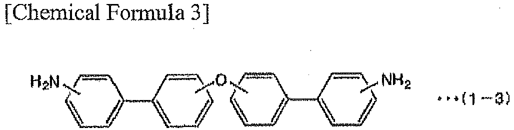 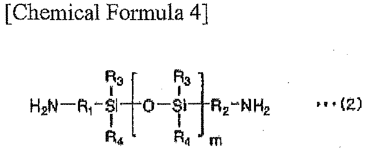 (In the general formula (2), R₁ and R₂ each independently represents a divalent aliphatic group having 1 to 5 carbon atoms or a divalent aromatic group having 6 or more carbon atoms, R₃ and R₄ each independently represents a monovalent aliphatic group having 1 to 5 carbon atoms or a monovalent aromatic group having 6 or more carbon atoms, and m represents an integer of 1 or more.) 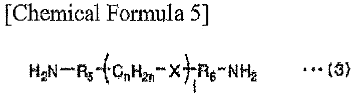 (In the general formula (3), R₅ and R₆ each independently represents an organic group including at least one selected from a group consisting of a carbonyl group, an oxycarbonyl group, an aromatic group having 6 or more carbon atoms, and an aliphatic group having one or more carbon atoms. X represents -O-, -S-, -NH-, -ONH-, or -OS-. 1 represents an integer of 1 to 50, and n represents an integer of 1 or more.) 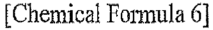 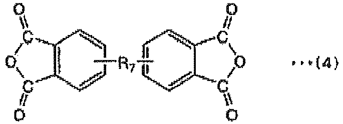 (In the general formula (4), R₇ represents a single bond, an oxygen atom, or a carbonyl group.)
[2] The polyimide resin composition according to [1], wherein the aromatic diamine (A) is represented by the following general formula (1), the aliphatic diamine (C) is represented by the following general formula (3-1), and the aromatic tetracarboxylic dianhydride (D) is represented by the following general formula (4-1). 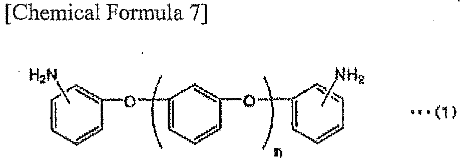 (In the general formula (1), n represents an integer of 1 to 20.) 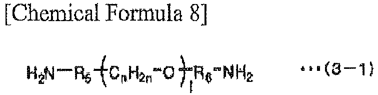 (In the general formula (3-1), R₅ and R₆ each independently represents an organic group including at least one selected from a group consisting of a carbonyl group, an oxycarbonyl group, an aromatic group having 6 or more carbon atoms, and an aliphatic group having one or more carbon atoms. 1 represents an integer of 1 to 50, and n represents an integer of 1 or more.) 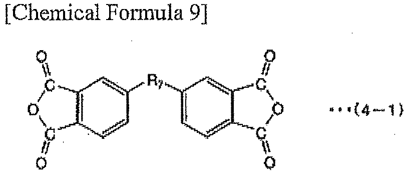 (In the general formula (4-1), R₇ represents a single bond, -O-, or a carbonyl group.)
[3] The polyimide resin composition according to [1] or [2], wherein the aliphatic diamine (C) is a diamine represented by the following general formula (3a), or a diamine represented by the following general formula (3b). 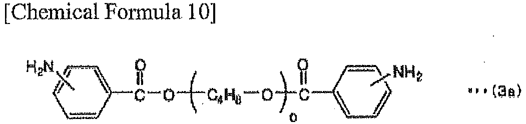 (In the general formula (3a), o represents an integer of 1 to 50.) 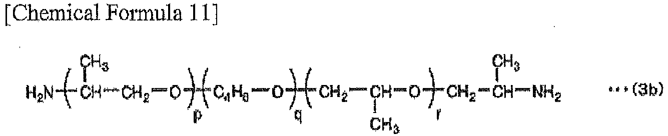 (In the general formula (3b), p, q, and r each independently represent an integer of 0 to 10.)
[4] The polyimide resin composition according to any of [1] to [3], wherein the polyimide is a block copolymer includes: an imide block b1 obtained from the silicone diamine (B) and the aromatic tetracarboxylic dianhydride (D); and an imide block b2 obtained from the aromatic diamine (A), the aliphatic diamine (C), and the aromatic tetracarboxylic dianhydride (D), the imide block (2) introduced at either end of the imide block b1.
[5] The polyimide resin composition according to any of [1] to [4], wherein the polyimide is obtained through the steps of: obtaining an oligomer by polycondensation of the silicone diamine (B) and the aromatic tetracarboxylic dianhydride (D) of more than 1 mol per mol of the silicone diamine (B); and subjecting the oligomer to further polycondensation with the aromatic diamine (A) and the aliphatic diamine (C).
[6] The polyimide resin composition according to any of [1] to [5], wherein the ratio of the total number of moles of the aromatic diamine (A) and the silicone diamine (B) is 0.01 to 0.6 to the total number of moles of the diamines and aromatic tetracarboxylic dianhydride constituting the polyimide.
[7] The polyimide resin composition according to any of [1] to [6], wherein the composition has a glass transition temperature of 40 to 150°C, and a thermal decomposition temperature of 350°C or more.
[8] The polyimide resin composition according to any of [1] to [7], further including an inorganic filler.
[9] The polyimide resin composition according to any of [1] to [8], further including one or more compounds selected from a group consisting of epoxy compounds, acrylate compounds, isocyanate compounds, maleimide compounds, and nadimide compounds.
[10] The polyimide resin composition according to any of [1] to [9], further including a polar solvent.
[11] An adhesive agent comprising the polyimide resin composition according to any of [1] to [10].

A second aspect of the present invention relates to a laminate and a device each including the polyimide resin composition.
[12] A laminate including: a base material; and a resin layer comprising the polyimide resin composition according to any of [1] to [9], the resin layer placed on the base material.
[13] A laminate including: a base material; and a resin layer placed on the base material, wherein the resin layer is formed by drying, at a temperature of 190°C or less, a coating layer comprising the polyimide resin composition according to [10] applied on the base material.
[14] The laminate according to [12] or [13], wherein the polyimide resin composition has a glass transition temperature of 40 to 150°C, and the base material is silicon, or a polyimide which has an elastic modulus of 1 GPa or more at room temperature and has a glass transition temperature of 240 to 440°C.
[15] A device including; a semiconductor element; and a resin layer obtained from the polyimide resin composition according to any of [1] to [10], the resin layer placed on a surface of the semiconductor element.

### EFFECTS OF THE INVENTION

According to the present invention, a polyimide resin composition can be provided which can achieve a balance between high heat resistance and low-temperature adhesion.

### BRIEF DESCRIPTION OF DRAWINGS

Fig. 1 is a side view illustrating an example of a device according to the present invention.
Fig. 2 is a side view illustrating another example of a device according to the present invention.
Fig. 3 is a side view illustrating another example of a device according to the present invention.
Fig. 4 is a schematic diagram illustrating an example of a ball grid array (BGA) package.
Fig. 5 is a schematic diagram illustrating an example of a chip on film (COF) package.
Fig. 6 is a schematic diagram illustrating an example of a wafer level chip size package (WL-CSP).

### BEST MODE FOR CARRYING OUT THE INVENTION

### 1. Polyimide Resin Composition

The polyimide resin composition according to the present invention contains a specific polyimide, and if necessary, can contain any other constituents (for example, such as inorganic fillers).

The polyimide contained in the polyimide resin composition is a polyimide obtained by reacting a diamine component containing specific aromatic diamine (A), silicone diamine (B), and aliphatic diamine (C) with an acid anhydride component containing a specific aromatic tetracarboxylic dianhydride (D).

The aromatic diamine (A) contained in the diamine component reacted is preferably an aromatic diamine including a keto group, an ether bond, or the like, and more preferably an aromatic diamine represented by any of the formulas (1-1) to (1-3).

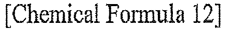

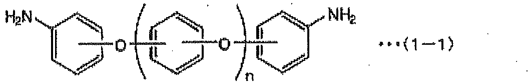

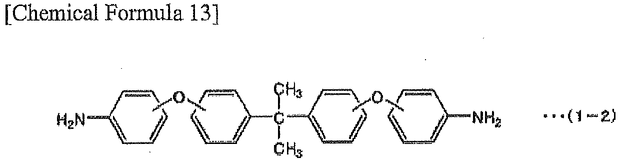

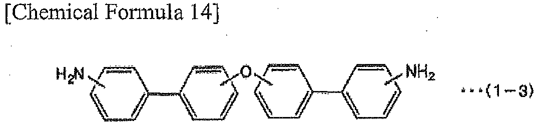

In the formula (1-1), n represents an integer of 1 to 20, preferably an integer of 1 to 13, and more preferably an integer of 1 to 9. It is to be noted that the benzene rings may each independently have a substituent (for example, an alkyl group having 1 to 10 carbon atoms) in the formulas (1-1) to (1-3).

When the aromatic diamine represented by any of the formulas (1-1) to (1-3) is used for a portion of the diamine component to be reacted, the heat resistance of an obtained polyimide can be increased, and the flexibility thereof can be also increased. Therefore, the heat resistance and adhesion of the polyimide resin composition are increased.

The aromatic diamine (A) is further preferably an aromatic diamine represented by the formula (1).

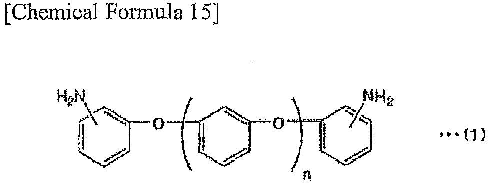

In the formula (1), n represents an integer of 1 to 20, preferably an integer of 1 to 13, and more preferably an integer of 1 to 9. In the formula (1), the benzene rings may each independently have a substituent (for example, an alkyl group having 1 to 10 carbon atoms).

When the aromatic diamine represented by the formula (1) is used for a portion of the diamine component to be reacted, the heat resistance of an obtained polyimide can be further increased, and the flexibility thereof can be also further increased. Therefore, the heat resistance and adhesion of the polyimide resin composition are further increased.

Examples of the diamine represented by the formula (1) include 1,3-bis(3-aminophenoxy)benzene, 1,3-bis(4-aminophenoxy)benzene, 1,3-bis(3-(3-aminophenoxy)phenoxy)benzene, 1,3-bis(3-(4-aminophenoxy)phenoxy)benzene, 1,3-bis(4-(3-aminophenoxy)phenoxy)benzene, 1,3-bis(3-(3-aminophenoxy)phenoxy)-2-methylbenzene, 1,3-bis(3-(4-aminophenoxy)phenoxy)-4-methylbenzene, 1,3-bis(4-(3-aminophenoxy)phenoxy)-2-ethylbenzene, 1,3-bis(3-(2-aminophenoxy)phenoxy)-5-sec-butylbenzene, 1,3-bis(4-(3-aminophenoxy)phenoxy)-2,5-dimethylbenzene, 1,3-bis(4-(2-amino-6-methylphenoxy)phenoxy)benzene, 1,3-bis(2-(2-amino-6-ethylphenoxy)phenoxy)benzene, 1,3-bis(2-(3-aminophenoxy)-4-methylphenoxy)benzene, 1,3-bis(2-(4-aminophenoxy)-4-tert-butylphenoxy)benzene, 1,4-bis(3-(3-aminophenoxy)phenoxy)-2,5-di-tert-butylbenzene, 1,4-bis(3-(4-aminophenoxy)phenoxy)-2,3-dimethylbenzene, 1,4-bis(3-(2-amino-3-propylphenoxy)phenoxy)benzene, 1,2-bis(3-(3-aminophenoxy)phenoxy)-4-methylbenzene, 1,2-bis(3-(4-aminophenoxy)phenoxy)-3-n-butylbenzene, and 1,2-bis(3-(2-amino-3-propylphenoxy)phenoxy)benzene. These may be used by themselves, or two or more thereof may be used in combination.

The silicone diamine (B) contained in the diamine component to be reacted is preferably a silicone diamine represented by the formula (2).

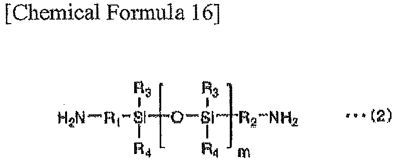

In the formula (2), R₁ and R₂ each independently represent a divalent aliphatic group having 1 to 5 carbon atoms or a divalent aromatic group having 6 or more carbon atoms. Examples of the divalent aliphatic group having 1 to 5 carbon atoms include an alkylene group having 1 to 5 carbon atoms, and examples of the divalent aromatic group having 6 or more carbon atoms include a phenylene group, a naphthylene group, and an anthracenylene group.

R₃ and R₄ each independently represent a monovalent aliphatic group having 1 to 5 carbon atoms or a monovalent aromatic group having 6 or more carbon atoms. The monovalent aliphatic group having 1 to 5 carbon atoms or monovalent aromatic group having 6 or more carbon atoms for R₃ and R₄ may be obtained by converting each the divalent aliphatic group or divalent aromatic group having 6 or more carbon atoms for R₁ and R₂ into a monovalent aliphatic or aromatic group.

In the formula (2), m represents an integer of 1 or more, preferably an integer of 1 to 8. In terms of suppressing the volatilization of cyclic siloxane, m is preferably 1.

When the diamine represented by the formula (2) is used for a portion of the diamine, the low-temperature adhesion of an obtained polyimide.

Examples of the diamine represented by the formula (2) include α,ω-bisamino polydimethylsiloxane, α,ω-bis(3-aminopropyl)polydimethylsiloxane, 1,3-bis(3-aminopropyl)tetramethyldisiloxane, 1,3-bis(3-aminopropyl)-1,1,3,3-tetramethyldisiloxane, bis(10-aminodecamethylene)tetramethyldisiloxane, bis(3-aminophenoxymethyl)tetramethyldisiloxane, α,ω-bis(3-aminopropyl)polydimethylphenylsiloxane, and a α,ω-bis(3-aminopropyl)poly(dimethylsiloxane-diphenylsiloxane)copolymer.

The aliphatic diamine (C) contained in the diamine component to be reacted is preferably an aliphatic diamine represented by the formula (3).

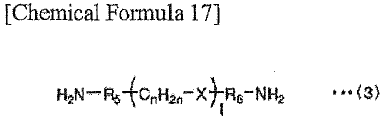

In the formula (3), R₅ and R₆ each independently represent at least one selected from a group consisting of a carbonyl group, an oxycarbonyl group, an aromatic group having 6 or more carbon atoms, and an aliphatic group having one or more carbon atoms. X represents -O-, -S-, -NH-, -ONH-, or -OS-. I represents an integer of 1 to 50, preferably an integer of 1 to 20. n represents an integer of 1 or more, preferably an integer of 2 to 10.

Examples of the organic group containing the aliphatic group having one or more carbon atoms include alkylene groups having 1 to 10 carbon atoms such as a methylene group, an ethylene group, and a propylene group, and examples of the organic group containing the aromatic group having 6 or more carbon atoms include a phenylene group. The organic group containing the aromatic group is preferable in terms of achieving heat resistance, and the organic group containing the aliphatic group is preferable in terms of achieving softness/flexibility.

The aliphatic diamine represented by the formula (3) is preferably a diamine represented by the formula (3-1). The aliphatic diamine represented by the formula (3) is more preferably a diamine represented by the formula (3a), or a diamine represented by the formula (3b).

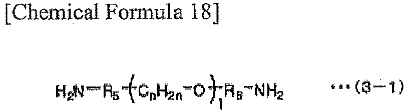

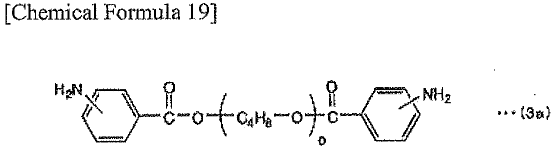

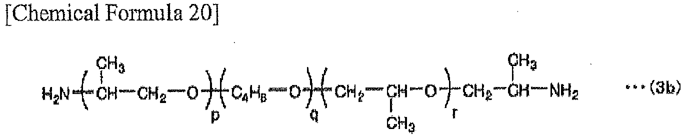

In the formula (3-1), R₅ and R₆ each independently represent at least one selected from a group consisting of a carbonyl group, an oxycarbonyl group, an aromatic group having 6 or more carbon atoms, and an aliphatic group having one or more carbon atoms. 1 represents an integer of 1 to 50, preferably an integer of 1 to 20. n represents an integer of 1 or more, preferably an integer of 2 to 10.

In the formula (3a), o represents an integer of 1 to 50, preferably an integer of 10 to 20. The repeating unit in the formula (3a) may be introduced as a block, or introduced randomly.

In the formula (3b), p, q, and r each independently represents an integer of 0 to 10. Each repeating unit in the formula (3b) may be introduced as a block, or introduced randomly. The aliphatic diamines represented by these formulas (3) have high softness, and can thus provide favorable adhesion even in small amounts.

Polyimides which are rich in the silicone diamine represented by the formula (2) are not preferred because the volatilization volume of cyclic siloxane is increased, although the polyimides have favorable low-temperature adhesion. In contrast, when the aliphatic diamine represented by the formula (3) is used in addition to the silicone diamine represented by the formula (2), favorable low-temperature adhesion is achieved even in the case of polyimides which are not rich in the silicone diamine represented by the formula (2).

The diamine component to be reacted contains other diamines than the diamines represented by the formulas (1-1) to (1-3), (2), and (3). Examples of the other diamines include m-phenylenediamine, o-phenylenediamine, p-phenylenediamine, m-aminobenzylamine, p-aminobenzylamine, bis(3-aminophenyl)sulfide, (3-aminophenyl)(4-aminophenyl)sulfide, bis(4-aminophenyl)sulfide, bis(3-aminophenyl)sulfoxide, (3-aminophenyl)(4-aminophenyl)sulfoxide, bis(3-aminophenyl)sulfone, (3-aminophenyl)(4-aminophenyl)sulfone, bis(4-aminophenyl)sulfone, 3,3'-diaminobenzophenone, 3,4'-diaminobenzophenone, 4,4'-diaminobenzophenone, 3,3-diaminodiphenylmethane, 3,4'-diaminodiphenylmethane, 4,4'-diaminodiphenylmethane, 4,4'-diaminodiphenylether, 3,3'-diaminodiphenylether, 3,4'-diaminodiphenylether, bis[4-(3-aminophenoxy)phenyl]methane, bis[4-(4-aminophenoxy)phenyl]methane, 1,1-bis[4-(3-aminophenoxy)phenyl]ethane, 1,1-bis[4-(4-aminophenoxy)phenyl]ethane, 1,2-bis[4-(3-aminophenoxy)phenyl]ethane, 1,1-bis[4-(4-aminophenoxy)phenyl]ethane, 2,2-bis[4-(3-aminophenoxy)phenyl]propane, 2,2-bis[4-(4-aminophenoxy)phenyl]propane, 2,2-bis[4-(3-aminophenoxy)phenyl]butane, 2,2-bis[3-(3-aminophenoxy)phenyl]-1, 1,1,3,3,3-hexafluoropropane, 2,2-bis[4-(4-aminophenaxy)phenyl]-1,1,1,3,3,3-hexafluoraprapane, 4,4-bis(3-aminophenoxy)biphenyl, 4,4-bis(4-aminophenoxy)biphenyl, bis[4-(3-aminophenoxy)phenyl]ketone, bis[4-(4-aminophenoxy)phenyl]ketone, bis[4-(3-aminophenoxy)phenyl]sulfide, bis[4-(4-aminophenoxy)phenyl]sulfide, bis[4-(3-aminophenoxy)phenyl]sulfoxide, bis[4-(aminophenoxy)phenyl]sulfoxide, bis[4-(3-aminophenoxy)phenyl]sulfone, bis[4-(4-aminophenoxy)phenyl]sulfone, 1,4-bis[4-(3-aminophenoxy)benzoyl]benzene, 1,3-bis[4-(3-aminophenoxy)benzoyl]benzene, 4,4'-bis[3-(4-aminophenoxy)benzoyl]diphenylether, 4,4'-bis[3-(3-aminophenoxy)benzoyl]diphenylether, 4,4'-bis[4-(4-amino-α,α-dimethylbenzyl)phenoxy]diphenylether, 4,4'-bis[4-(4-amino-α,α-dimethylbenzyl)phenoxy]diphenylsulfone, 4,4'-bis[4-{4-(4-aminophenoxy)phenoxy}phenyl] sulfone, 1,4-bis[4-(4-aminophenoxy)-α,α- dimethylbenzyl]benzene, 1,3-bis[4-(4-aminophenoxy)-α,α-dimethylbenzyl]benzene, 1,2-dodecanediamine, and norbornane diamine.

The acid anhydride component to be reacted is not particularly limited, but preferably an aromatic tetracarboxylic dianhydride in terms of heat resistance, more preferably an aromatic tetracarboxylic dianhydride represented by the formula (4), and particularly preferably an aromatic tetracarboxylic dianhydride represented by the formula (4-1).

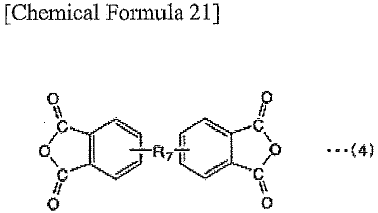

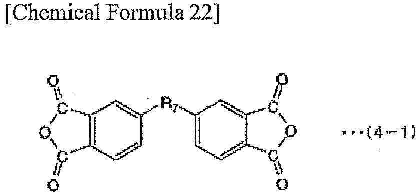

In the formulas (4) and (4-1), R₇ represents a single bond, -O-, or a carbonyl group. This polyimide which has an acid dianhydride as a constituent tends to achieve favorable heat resistance without extremely damaging the softness. The benzene rings included in the tetracarboxylic dianhydrides represented by the formulas (4) and (4-1) may have a substituent (for example, a fluorine atom).

Examples of the aromatic tetracarboxylic dianhydrides represented by the formula (4) and (4-1) include 2,2',3,3'-benzophenonetetracarboxylic dianhydride, 3,3',4,4'-benzophenonetetracarboxylic dianhydride, 2,2',3,3'-biphenyltetracarboxylic dianhydride, 3,3',4,4'-biphenyltetracarboxylic dianhydride, 4,4'-oxydiphthalic dianhydride, 2,2'-difluoro-3,3',4,4'-biphenyltetracarboxylic dianhydride, 5,5'-difluoro-3,3',4,4'-biphenyltetracarboxylic dianhydride, 6,6'-difluoro-3,3',4,4'-biphenyltetracarboxylic dianhydride, 2,2',5,5'6,6'-hexafluoro-3,3',4,4'-biphenyltetracarboxylic dianhydride, 2,2'-bis(trifluoromethyl)-3,3',4,4'-biphenyltetracarboxylic dianhydride, 5,5'-bis(trifluoromethyl)-3,3',4,4'-biphenyltetracarboxylic dianhydride, 6,6'-bis(trifluoromethyl)-3,3',4,4'-biphenyltetracarboxylic dianhydride, 2,2',5,5'-tetrakis(trifluoromethyl)-3,3',4,4'-biphenyltetracarboxylic dianhydride, 2,2',6,6'-tetrakis(trifluoromethyl)-3,3',4,4'-biphenyltetracarboxylic dianhydride, 5,5',6,6'-tetrakis(trifluoromethyl)-3,3',4,4'-biphenyltetracarboxylic dianhydride, and 2,2',5,5'6,6'-hexakis(trifluoromethyl)-3,3',4,4'-biphenyltetracarboxylic dianhydride.

The acid anhydride component to be reacted may contain other tetracarboxylic dianhydrides than the tetracarboxylic dianhydride represented by the formula (4). The other tetracarboxylic dianhydrides are preferably aromatic tetracarboxylic dianhydrides in terms of heat resistance, and preferably aliphatic tetracarboxylic dianhydrides in terms of softness.

Examples of the other tetracarboxylic dianhydrides include: oxydiphthalic acid, pyromellitic dianhydride, 3-fluoropyromellitic dianhydride, 3,6-difluoropyromellitic dianhydrides, 3,6-bis(trifluoromethyl)pyromellitic dianhydride, 1,2,3,4-benzenetetracarboxylic dianhydride, 3,3",4,4"-terphenyltetracarboxylic dianhydride, 3,3"',4,4"'-quaterphenyltetracarboxylic dianhydride, 3,3"",4,4""-quinquephenylphenyltetracarboxylic dianhydride, methylene-4,4'diphthalic dianhydride, 1,1-ethylidene-4,4'-diphthalic dianhydride, 2,2-propylidene-4,4'-diphthalic dianhydride, 1,2-ethylene-4,4'-diphthalic dianhydride, 1,3-trimethylene-4,4'-diphthalic dianhydride, 1,4-tetramethylene-4,4'-diphthalic dianhydride, 1,5-pentamethylene-4,4'-diphthalic dianhydride, 2,2-bis(3,4-dicarboxyphenyl)-1,1,1,3,3,3-hexafluoropropane dianhydride, difluoromethylene-4,4'-diphthalic dianhydride, 1,1,2,2-tetrafluoro-1,2-ethylene-4,4'-diphthalic, dianhydride, 1,1,2,2,3,3-hexafluoro-1,3-trimethylene-4,4'-diphthalic dianhydride, 1,1,2,2,3,3,4,4-octafluoro-1,4-tetramethylene-4,4'-diphthalic dianhydride, 1,1,2,2,3,3,4,4,5,5-decafluoro-1,5-pentamethylene-4,4'-diphthalic dianhydride, tio-4,4'-diphthalic dianhydride, sulfonyl-4,4'-diphthalic dianhydride, 1,3-bis(3,4-dicarboxyphenyl)-1,1,3,3-tetramethylsiloxane dianhydride, 1,3-bis(3,4-dicarboxyphenyl)benzene dianhydride, 1,4-bis(3,4-dicarboxyphenyl)benzene dianhydride, 1,3-bis(3,4-dicarboxyphenoxy)benzene dianhydride, 1,4-bis(3,4-dicarboxyphenoxy)benzene dianhydride, 1,3-bis[2-(3,4-dicarboxyphenyl)-2-propyl]benzene dianhydride, 1,4-bis[2-(3,4-dicarboxylphenyl)-2-propyl]benzene dianhydride, bis[3-(3,4-dicarboxyphenoxy)phenyl]methane dianhydride, bis[4-(3,4-dicarboxyphenoxy)phenyl]methane dianhydride, 2,2-bis[3-(3,4-dicarboxyphenoxy)phenyl]propane dianhydride, 2,2-bis[4-(3,4-dicarboxyphenoxy)phenyl]propane dianhydride, 2,2-bis[3-(3,4-dicarboxyphenoxy)phenyl]-1,1,1,3,3,3-hexafluoropropane dianhydride, 2,2-bis[4-(3,4-dicarboxyphenoxy)phenyl] propane dianhydride, bis(3,4-dicarboxyphenoxy)dimethylsilane dianhydride, 1,3-bis(3,4-dicarboxyphenoxy)-1,1,3,3-tetramethyldisiloxane dianhydride, 2,3,6,7-naphthalenetetracarboxylic dianhydride, 1,2,5,6-naphthalenetetracarboxylic dianhydride, 3,4,9,10-perylenetetracarboxylic dianhydride, 2,3,6,7-anthracenetetracarboxylic dianhydride, 1,2,7,8-phenanthrenetetracarboxylic dianhydride, 1,2,3,4-butanetetracarboxylic dianhydride, 1,2,3,4-cyclobutanetetracarboxylic dianhydride, cyclopentanetetracarboxylic dianhydride, cyclohexane-1,2,3,4-tetracarboxylic dianhydride, cyclohexane-1,2,4,5-tetracarboxylic dianhydride, 3,3',4,4'-bicyclohexyltetracarboxylic dianhydride, carbonyl-4,4'-bis(cyclohexane-1,2-dicarboxylic)dianhydride, methylene-4,4'-bis(cyclohexane-1,2-dicarboxylic)dianhydride, 1,2-ethylene-4,4'-bis(cyclohexane-1,2-dicarboxylic)dianhydride, 1,1-ethylidene-4,4'-bis(cyclohexane-1,2-dicarboxylic)dianhydride, 2,2-propylidene-4,4'-bis(cyclohexane-1,2-dicarboxylic)dianhydride, 1,1,1,3,3,3-hexafluoro-2,2-propylidene-4,4'-bis(cyclohexane-1,2-dicarboxylic)dianhydri de, oxy-4,4'-bis(cyclohexane-1,2-dicarboxylic)dianhydride, thio-4,4'-bis(cyclohexane-1,2-dicarboxylic)dianhydride, sulfonyl-4,4'-bis(cyclohexane-1,2-dicarboxylic)dianhydride, 3,3'-difluoroxy-4,4'-diphthalic dianhydride, 5,5'-difluoroxy-4,4'-diphthalic dianhydride, 6,6'-difluoroxy-4,4'-diphthalic dianhydride, 3,3'5,5',6,6'-hexafluoroxy-4,4'-diphthalic dianhydride, 3,3'-bis(trifluoromethyl)oxy-4,4'-diphthalic dianhydride, 5,5'-bis(trifluoromethyl)oxy-4,4'-diphthalic dianhydride, 6,6'-bis(trifluoromethyl)oxy-4,4'-diphthalic dianhydride, 3,3',5,5'-tetrakis(trifluoromethyl)oxy-4,4'-diphthalic dianhydride, 3,3',6,6'-tetrakis(trifluoromethyl)oxy-4,-diphthalic dianhydride, 5,5',6,6'-tetrakis(trifluoromethyl)oxy-4-,4'-diphthalic dianhydride, 3,3'5,5',6,6'-hexakis(trifluoromethyl)oxy-4,4'-diphthalic dianhydride, 3,3'-difluorosulfonyl-4,4'-diphthalic dianhydride, 5,5' -difluorosulfonyl-4,4' -diphthalic dianhydride, 6,6'-difluorosulfonyl-4,4'-diphthalic dianhydride, 3,3',5,5',6,6'-hexafluorosulfonyl-4,4'-diphthalic dianhydride, 3,3'-bis(trifluoromethyl)sulfonyl-4,4'-diphthalic dianhydride, 5,5'-bis(trifluoromethyl)sulfonyl-4,4'-diphthalic dianhydride, 6,6'-bis(trifluoromethyl)sulfonyl-4,4'-diphthalic dianhydride, 3,3',5,5'-tetrakis(trifluoromethyl)sulfonyl-4,4'-diphthalic dianhydride, 3,3',6,6'-tetrakis(trifluoromethyl)sulfonyl-4,4'-diphthalic dianhydride, 5,5'6,6'-tetrakis(trifluoromethyl)sulfonyl-4,4'-diphthalic dianhydride, 3,3',5,5'6,6'-hexakis(trifluoromethyl)sulfonyl-4,4'-diphthalic dianhydride, 3,3'-difluoro-2,2-perfluoropropylidene -4,4'-diphthalic dianhydride, 5,5'-difluoro-2,2-perfluoropropylidene -4,4'-diphthalic dianhydride, 6,6'-difluoro-2,2-perfluoropropylidene -4,4'-diphthalic dianhydride, 3,3',5,5'6,6'-hexafluoro-2,2-perfluoropropylidene -4,4'-diphthalic dianhydride, 3,3'-bis(trifluoromethyl)-2,2-perfluoropropylidene -4,4'-diphthalic dianhydride, 5,5'-bis(trifluoromethyl)-2,2-perfluoropropylidene-4,4'-diphthalic dianhydride, 6,6'-difluoro-2,2-perfluoropropylidene-4,4'-diphthalic dianhydride, 3,3',5,5'-tetrakis(trifluoromethyl)-2,2-perfluoropropylidene-4,4'-diphthalic dianhydride, 3,3',6,6'-tetrakis(trifluoromethyl)-2,2-perfluoropropylidene-4,4'-diphthalic dianhydride, 5,5',6,6'-tetrakis(trifluoromethyl)-2,2-perfluoropropylidene-4,4'-diphthalic dianhydride, 3,3',5,5'6,6'-hexakis(trifluoromethyl)-2,2-perfluoropropylidene-4,4'-diphthalic dianhydride, 9-phenyl-9-(trifluoromethyl)xanthene-2,3,6,7-tetracarboxylic dianhydride, 9,9-bis(trifluoromethyl)xanthene-2,3,6,7-tetracarboxylic dianhydride, bicyclo[2,2,2]octo-7-en-2,3,5,6-tetracarboxylic dianhydride, 9,9-bis[4-(3,4-dicarboxy)phenyl]fluorene dianhydride, 9,9-bis[4-(2,3-dicarboxy)phenyl]fluorene dianhydride, and ethylene glycol bistrimellitate dianhydride.

The molar ratio between the diamine component (a mol) and acid anhydride component (b mol) to be reacted preferably fall within the range of b/a = 0.8 to 1.2. This is to achieve a polymer with not less than a certain degree of polymerization.

In terms of balance between the heat resistance and adhesion of the polyimide, the molar ratio of the total of the aromatic diamine (A) and silicone diamine (B) to the total of the total diamine component and total acid anhydride to be reacted is preferably 0.01 to 0.6, and more preferably 0.1 to 0.3. If the molar ratio of the total of the aromatic diamine (A) and silicone diamine (B) to the total of the total diamine component and total acid anhydride is excessively high, there is a possibility that the varnish stability will be decreased. In addition, the molar ratio the total of the silicone diamine (B) and aliphatic diamine (C) to the aromatic diamine (A) to be reacted is preferably 0.25 to 3.0, and more preferably 0.3 to 2.5. This is because the low-temperature adhesion is less likely to be achieved when the total ratio of the silicone diamine (B) and aliphatic diamine (C) to the aromatic diamine (A) is less than 0.25, whereas the heat resistance is more likely to be decreased when the total ratio is more than 3.0.

In terms of achieving heat resistance while suppressing the volatilization of cyclic siloxane, the molar ratio of the silicone diamine (B) to the aliphatic diamine (C) is preferably 0.1 to 1.0, and more preferably 0.2 to 0.8. This is because the heat resistance (thermal decomposition temperature) is more likely to be decreased when the molar ratio of the silicone diamine (B) to the aliphatic diamine (C) is less than 0.1, whereas the volatilization of cyclic siloxane is increased when the molar ratio is more than 1.0. More specifically, the silicone diamine (B) is less likely to be decomposed, and has higher heat resistance than the aliphatic diamine (C), while cyclic siloxane and the unreacted silicone diamine will be volatilized if the silicone diamine (B) is contained excessively. Therefore, the content rate of the silicone diamine (B) is preferably not more than a certain level.

The molar ratio of the silicone diamine (B) to the total of the total diamine component and total acid anhydride to be reacted is preferably 0.01 to 0.28, and more preferably 0.04 to 0.15. When the molar ratio of the silicone diamine (B) to the total of the total diamine component and total acid anhydride is excessively low, there is a possibility that the adhesion to the silicon substrate will be decreased. On the other hand, when the molar ratio of the silicone diamine (B) to the total of the total diamine component and total acid anhydride is excessively high, there is a possibility that the varnish stability will be decreased.

In addition, the molar ratio of the silicone diamine (B) contained in the total diamine component to be reacted is preferably 0.06 to 0.28, and more preferably 0.1 to 0.2. When the molar ratio of the silicone diamine (B) contained in the total diamine component is excessively low, there is a possibility that the adhesion to the silicon substrate will be decreased. On the other hand, when the molar ratio of the silicone diamine (B) contained in the total diamine component is excessively high, there is a possibility that the transparency of the film will be decreased.

The heat resistance of the polyimide resin composition including the constituent unit derived from the silicone diamine (B) and the aromatic tetracarboxylic dianhydride is considered to depend mainly on the volatilization of the unpolymerized silicone diamine (B) and the decomposition of the constituent unit. On the other hand, the heat resistance of a polyimide including no silicone diamine unit is considered to depend mainly on the decomposition of the constituent unit derived from the aliphatic diamine (C) and the aromatic tetracarboxylic dianhydride (D).

The molar ratio of the total of the aromatic diamine (A), silicone diamine (B), and aliphatic diamine (C) to the total diamine component to be reacted, is 0.7 or more, and preferably 0.9 or more, and the molar ratio of the aromatic tetracarboxylic dianhydride (D) to the total of the total acid anhydride to be reacted is 0.7 or more, and preferably 0.9 or more. These ratios make it likely that high heat resistance and excellent low-temperature adhesion are achieved.

This polyimide obtained by reacting the diamine component with the acid anhydride component may be a random polymer or a block polymer, and is preferably a block polymer. This is because the properties of each diamine component are likely to be obtained.

Above all, a block copolymer is preferable which includes an imide block b1 derived from the silicone diamine (B) and the aromatic tetracarboxylic dianhydride (D), and includes an imide block b2 derived from a diamine other than the silicone diamine (B) (the aromatic diamine (A), the aliphatic diamine (C), and the like) and the aromatic tetracarboxylic dianhydride (D), which is introduced at either end of the imide block b1. As described above, when the imide block b1 configured with the use of the silicone diamine (B) is confined at a site distant from the end of the molecular chain, cyclic siloxane can be made less likely to be volatilized, and the thermal decomposition temperature of the polyimide can be increased. In addition, when the reaction of all of the silicone diamine (B) with a portion of the acid anhydride component is completed before reacting the other diamine with the acid anhydride component, the unpolymerized silicone diamine (B) can be reduced. Therefore, the volatilization of the unpolymerized silicone diamine (B) can be reduced.

The method for synthesizing this block copolymer is not particularly limited, and examples of the method include, for example, the following methods 1) and 2). Method 1): As a first step, the silicone diamine (B) is reacted with the aromatic tetracarboxylic dianhydride (D) in an excessive amount to obtain a first imide block (imide block b1). As a second step, a diamine other than the silicone diamine (B) is further added to the solution containing the obtained first imide block to link, at either end of the first imide block, a second imide block (imide block b2) derived from a diamine other than the silicone diamine (B) and the aromatic tetracarboxylic dianhydride (D), and thus obtain a block copolymer.

Method 2): A solution containing a first imide block (imide block b1) obtained by reacting the silicone diamine (B) with the aromatic tetracarboxylic dianhydride (D) and a solution containing a second imide block (imide block b2) obtained by reacting a diamine other than the silicone diamine (B) with the aromatic tetracarboxylic dianhydride (D) are synthesized in predetermined solvents, respectively. The solutions are mixed and stirred under a predetermined condition to provide a block copolymer.

The additive amount of the aromatic tetracarboxylic dianhydride (D) in an excessive amount in the first step of the 1) may be, for example, more than 1 mol per mol of the silicone diamine (B).

The viscosity of a solution with 23 weight% of the polyimide dispersed in a mixed solvent ofNMP and trimethylbenzene, which is measured by an E-type viscometer at 25°C, is preferably 5.0 × 10² to 1.0 × 10⁶ mPa·s, and more preferably 1.0 × 10³ to 5.0 × 10⁴ mPa·s. This viscosity improves the mechanical strength and the like of the obtained polyimide film.

The polyimide resin composition may contain, if necessary, optional components other than the polyimide. The optional components may be, for example, other resins than the polyimide resin, additives such as surface modifiers, and fillers.

The other resins are not particularly limited, and may be epoxy compounds such as bisphenol A epoxy compounds and bisphenol F epoxy compounds; acrylate compounds such as carboxyethyl acrylates, propylene glycol acrylates, ethoxylated phenyl acrylates, and aliphatic epoxy acrylates; isocyanate compounds such as methylene bisphenyl diisocyanate (MDI), toluene diisocyanate (TDI), hexamethylene diisocyanate (HDI), and xylene diisocyante (XDI); maleimide compounds such as 4,4'-diphenylmethane bismaleimide, bis-(3-ethyl-5-methyl-4-maleimidephenyl)methane, m-phenylene bismaleimide, and aminophenoxy benzene-bismaleimide (APB-BMI); and nadimide such as alkenyl-substituted nadimides. For example, in the case of desiring to provide the adhesive resin composition with photosensitivity, the adhesive resin composition may be allowed to contain a light curing resin or a light curing agent such as an acrylate compound.

The filler is preferably an inorganic filler in terms of improvement in heat resistance and heat conductivity. The inorganic filler is not particularly limited, as long as the filler is any inorganic substance which has electrical insulation and heat release performance. Examples of the material thereof include boron nitride, alumina, hydrated alumina, silicon oxide, silicon nitride, silicon carbide, diamond, hydroxyapatite, and barium titanate, and the material is preferably boron nitride or the like. The content of the inorganic filler in the adhesive resin composition may be 60 vol% or less, and preferably 50 vol% or less.

Examples of the surface modifier include a silane coupling agent. The surface modifier may be used for treating the surface of the filler. This use can improve the compatibility with the polyimide, and control the agglomeration and dispersion of the filler.

The polyimide resin composition may be in the form of infinite varnish or a film. The thickness of the film obtained from the polyimide resin composition is preferably 10 to 200 µm typically, for example, in the case of using the composition as a film adhesive agent. The polyimide varnish obtained from the polyimide resin composition may contain a polar solvent, if necessary. The resin solid content concentration in the polyimide varnish is preferably 5 to 50 weight%, and more preferably 10 to 30 weight%.

The type of the polar solvent is not particularly limited, and the polar solvent may be N,N-dimethylformamide, N,N-dimethylacetoamide, N,N-diethylformamide, N,N-diethylacetoamide, N,N-dimethylmethoxyacetoamide, dimethylsulfaxide, hexamethylphosphoramide, N-methyl-2-pyrrolidone, dimethyl sulfone, 1,3,5-trimethylbenzene, and in addition, mixed solvents of two or more of these solvents, or mixed solvents of these solvents with toluene, xylene, benzonitrile, dioxane, and cyclohexane.

The polyimide varnish can be obtained by blending the acid anhydride component and the diamine component in a solvent, developing a dehydration reaction to synthesize an amide acid, and further carrying out imidization. The blended acid anhydride component and diamine component may be the respective components mentioned above.

The polyimide for use in the polyimide resin composition according to the present invention has favorable heat resistance and low-temperature adhesion, because the polyimide includes constituent units derived from each of the diamines (A) to (C) in a balanced manner. Specifically, the constituent unit derived from the specific aromatic diamine (A) provides favorable heat resistance. In addition, the constituent unit derived from the specific silicone diamine (B) and the constituent unit derived from the specific aliphatic diamine (C) provide favorable low-temperature adhesion, and above all, the constituent unit derived from the silicone diamine (B) provides favorable low-temperature adhesion and heat resistance. Furthermore, the imide block b1 derived from the silicone diamine (B) and the aromatic tetracarboxylic dianhydride (D) can be introduced at a site distant from the end of the molecular chain of the polyimide to reduce the volatilization of cyclic siloxane or the unpolymerized silicone diamine (B), and the heat resistance can be thus further increased.

Therefore, the polyimide resin composition according to the present invention has a glass transition temperature of 40 to 150°C, and preferably 50 to 140°C, and has a thermal decomposition temperature of 350°C. The glass transition temperature of the polyimide resin composition is obtained from the peak value of obtained loss tangent tan δ = E"/E' by measuring a storage elastic modulus E' and a loss elastic modulus E" for a film sample (thickness: approximately 60 µm) of the polyimide resin composition in accordance with the temperature dispersion measurement (tensile mode) of solid viscoelasticity.

The thermal decomposition temperature of the polyimide resin composition can be measured by a thermogravimetric measurement apparatus (Product Name: TGA-51) from Shimadzu Corporation. Specifically, a film sample including the polyimide resin composition is subjected to grinding, and put into a quartz crucible as an attachment of the Product Name: TGA-51 from Shimadzu Corporation, and the thermolytic behavior (decrease in weight) is then measured from room temperature up to 800°C under a nitrogen atmosphere. Then, the heating temperature at which the initial sample weight is decreased by 5 weight% can be found as the thermal decomposition temperature (at the point of the decrease by 5 weight%).

### 2. Application of Polyimide Resin Composition

The polyimide resin composition according to the present invention has favorable heat resistance and low-temperature adhesion (favorable low-temperature adhesion with various types of base materials including, in particular, inorganic base materials) as mentioned previously. Therefore, the polyimide resin composition according to the present invention is used as adhesive materials (adhesive agents), protective materials, interlayer insulating materials, and the like, and preferably, as adhesive materials for silicon, ceramics, metals, and the like.

For example, the polyimide resin composition is used preferably for bonding one semiconductor chip to other semiconductor chip in a device including one semiconductor chip and other semiconductor chip stacked thereon, or bonding a substrate to a semiconductor chip in a device including a substrate and a semiconductor chip mounted thereon. Other semiconductor chip stacked on one semiconductor chip can be, for example, a semiconductor chip mounted on a substrate. The substrate with a semiconductor chip mounted thereon can be, for example, a semiconductor package or a circuit board.

More specifically, a device according to the present invention has a semiconductor chip, and a polyimide resin composition layer placed on at least one surface of the semiconductor chip. The polyimide resin composition layer is a layer obtained from the polyimide resin composition according to the present invention. While the polyimide resin composition layer may be placed on a surface with a terminal of a semiconductor chip formed thereon (terminal formation surface), or placed on a different surface from the terminal formation surface, it is preferable to place the polyimide resin composition layer on a different surface from the terminal formation surface.

The thickness of the polyimide resin composition layer is preferably, depending on the application, for example, approximately 1 to 100 µm in the case of using the polyimide resin composition layer as an adhesive layer. When the polyimide resin composition layer is used as a protective layer for a circuit or the like, the thickness is preferably approximately 2 to 200 µm.

Examples of the semiconductor chip include diodes, transistors, and integrated circuits (IC), and also include power elements.

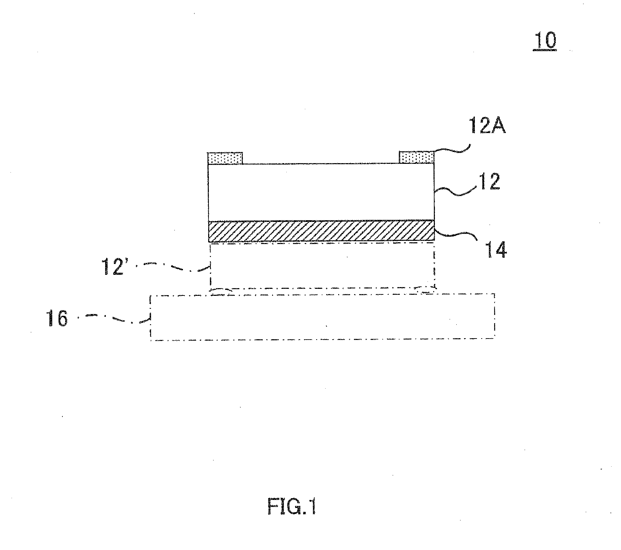

Fig. 1 is a side view illustrating an example of a device according to the present invention. As shown in Fig. 1, the device 10 includes a semiconductor chip 12, and a polyimide resin composition layer 14 placed on a surface of the semiconductor chip 12, which is different from the terminal formation surface. Furthermore, with the polyimide resin composition layer 14 interposed therebetween, the semiconductor chip 12 is stacked on other semiconductor chip 12' or the like placed on a substrate 16. The terminal 12A of the semiconductor chip 12 is connected to a lead frame (not shown) or the like by, for example, wire bonding or the like.

Thus, the semiconductor 12 can be stacked and fixed to the other semiconductor chip 12' mounted on the substrate 16, with the polyimide resin composition layer 14 interposed therebetween. In addition, even when the semiconductor chips 12 and 12' are power elements, or the like which produce a lot of heat, favorable adhesion can be maintained because the polyimide resin composition layer 14 has high heat resistance.

In addition, when the polyimide resin composition layer according to the present invention further contains an inorganic filler, the layer can be also preferably used, for example, as a material for the substrate 16, because the layer has favorable thermal conductivity.

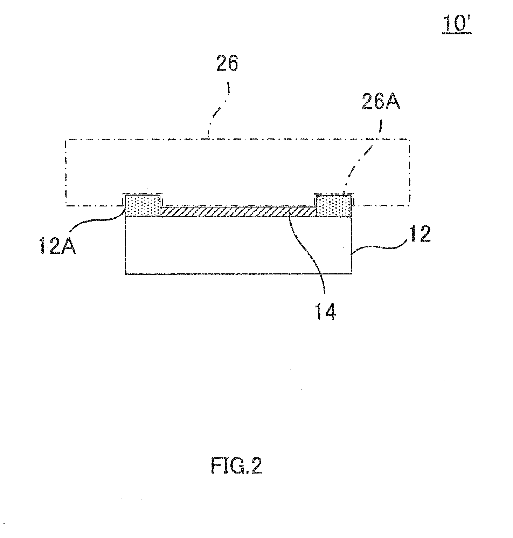

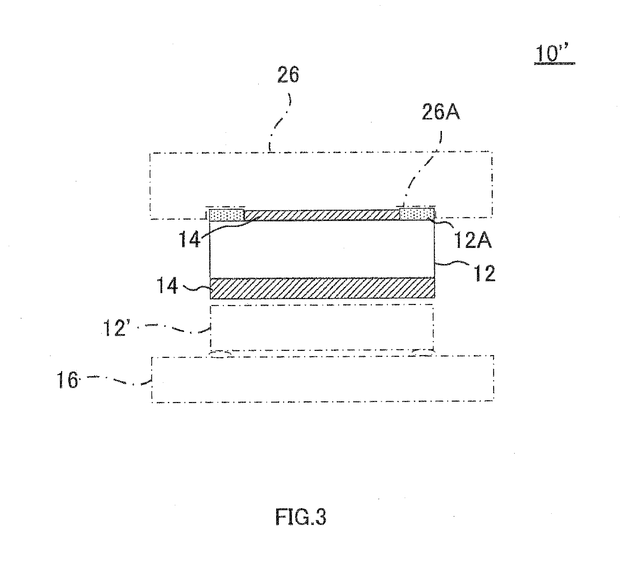

Figs. 2 and 3 are side views illustrating other examples of the device according to the present invention. The device 10' shown in Fig. 2 is configured as in the case of Fig. 1, except that the polyimide resin composition layer 14 is placed on only a terminal formation surface of the semiconductor chip 12. The device 10" shown in Fig. 3 is configured as in the case of Fig. 1, except that the polyimide resin composition layer 14 is placed on both surfaces of the semiconductor chip 12, the terminal formation surface and the surface which is different from terminal formation surface. In Figs. 2 and 3, a substrate 26 has recessed portions 26A into which the terminals 12A of the semiconductor chip 12 are inserted.

In Fig. 2, the semiconductor chip 12 can be bonded to the substrate 26 while protecting, for example, the terminal formation surface of the semiconductor chip 12 or the circuit formation surface of the substrate 26 with the polyimide resin composition layer 14. In addition, in Fig. 3, the semiconductor chip 12 can be also bonded to the substrate 26 with the polyimide resin composition layer 14 interposed therebetween while being stacked and fixed to the other semiconductor chip 12' (bonded to substrate 16) with the polyimide resin composition layer 14 interposed therebetween. In this case, the polyimide resin composition layer 14 placed on the terminal formation surface of the semiconductor chip 12 may have any thickness to the extent that the terminal 12A can be exposed, which is not particularly limited.

This semiconductor chip with the polyimide resin composition layer formed (the semiconductor chip with the adhesive agent) may be obtained by separating, into individual pieces, a laminate including a silicon wafer (before the separation into individual pieces) and the polyimide resin composition layer formed on one surface of the silicon wafer, or by forming the polyimide resin composition layer on separated individual semiconductor chips. The polyimides resin composition layer may be formed by applying the polyimide resin composition in the form of varnish to a silicon wafer or a semiconductor chip and then drying the composition, or by thermocompression bonding of the polyimide resin composition in the form of a film to a silicon wafer or a semiconductor chip.

The method for applying the polyimide resin composition in the form of varnish is not particularly limited, and can be, for example, a dispense method, an ink-jet method, a screen printing method, or an offset printing method. The drying temperature of the coating film of the polyimide resin composition is preferably kept as low as possible in terms of reduction in damage to the semiconductor chip due to heat, and kept approximately 190°C or less, and preferably approximately 150 to 190°C.

As described above, the polyimide resin composition according to the present invention has favorable low-temperature adhesion. Therefore, the polyimide resin composition layer according to the present invention can bond a semiconductor chip to other semiconductor chip, a substrate, or the like at relatively low temperatures in a favorable manner. In addition, the polyimide resin composition layer according to the present invention also has a thermal decomposition temperature (high heat resistance), and thus, can suppress the volatilization of cyclic siloxane, suppress defective contacts due to the volatilization, and further maintain favorable adhesion without peeling, even in the case of a semiconductor chip or the like which produce a lot of heat.

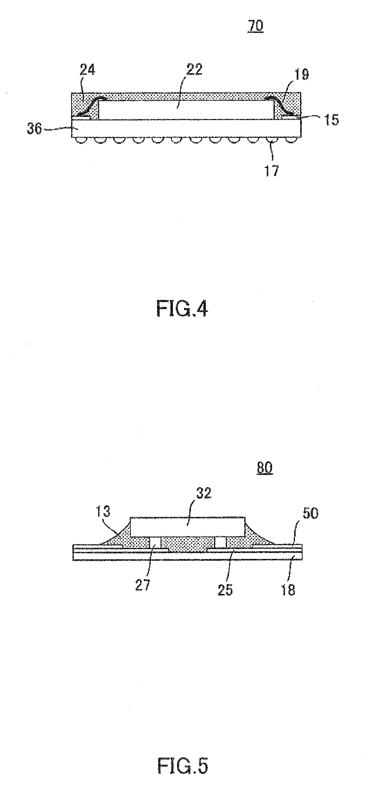

In addition, the polyimide resin composition according to the present invention is also preferably used as a material constituting a sealing layer or an underfill layer for various types of semiconductor packages, by making use of the excellent adhesion and heat resistance. Fig. 4 is a schematic diagram illustrating an example of a ball grid array (BGA) package. As shown in Fig. 4, a BGA package 70 has a semiconductor chip 22 placed on one surface of a substrate 36, and has a plurality of bumps 17 formed on the other surface thereof. A semiconductor chip 22 has a terminal (not shown) connected by a wire 19 to a lead 15 on the substrate 36. Further, the upper surface of the semiconductor chip 22 is sealed with a sealing layer 24. The polyimide resin composition according to the present invention can be used as a sealing agent for constituting the sealing layer 24 of the BGA package 70.

Fig. 5 is a schematic diagram illustrating an example of a chip on film (COF) package. As shown in Fig. 5, a COF package 80 has a semiconductor chip 32 placed on one surface of a film substrate 18 with bumps 27 interposed therebetween. It is to be noted that the bumps 27 are connected to leads 25 on the film substrate 18. Further, the gap between the semiconductor chip 32 and the film substrate 18 is sealed with an underfill layer 13. It is to be noted that reference numeral 50 in Fig. 5 denotes solder resist. The polyimide resin composition according to the present invention can be used as an underfill material for constituting the underfill 13 of the COF package 80.

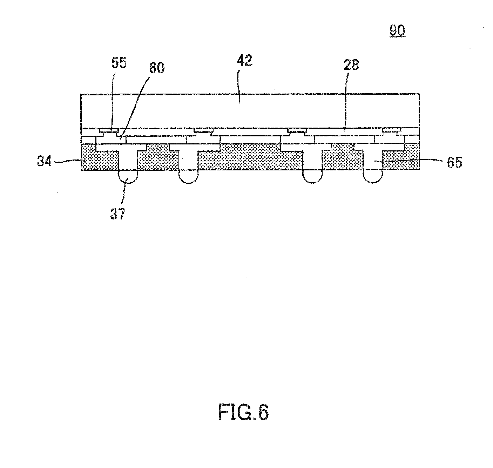

Fig. 6 is a schematic diagram illustrating an example of a wafer level chip size package (WL-CSP). As shown in Fig. 6, a package 90 includes a semiconductor chip 42, a film substrate 28 placed on one surface of the semiconductor chip 42, and a plurality of Al pads 55. Bump underlying metal layers 60, Cu posts 65, and bumps 37 are sequentially connected to the Al pads 55. Further, the upper surface of the film substrate 28 and the gap between the Cu posts 65 are sealed with a sealing layer 34. The polyimide resin composition according to the present invention can be used as a sealing agent for constituting the sealing layer 34 of the package 90.

In addition, the polyimide resin composition according to the present invention can be used as a binder (adhesive paste) for fixing an electrode material constituting an electrode for use in a battery, onto the surface of an electrode plate (electrode foil). In particular, the polyimide resin composition is preferred as a binder for fixing silicon particles attracting attention as a high-capacity negative electrode material (negative electrode active material) for a lithium ion battery, onto the surface of a negative electrode plate (negative electrode foil).

Electrodes of a secondary battery such as a lithium ion battery typically include an electrode plate (foil), and an electrode layer formed in the form of a layer on the surface of the electrode plate (foil). The electrode layer includes an electrode active material of a number of particles, and a binder. It is to be noted that the electrode active material of a number of particles is firmly fixed in the form of a layer by the binder onto the surface of the electrode plate (foil). For example, in the case of a lithium ion battery, the electrode active material repeats the storage and release of lithium ions, thus expands and contracts severely in the charge and discharge process, and the electrode active material is estimated to be likely to peel (drop off) from the binder. Therefore, the binder to serve as a constituent material of the electrode requires an adhesion force which can withstand the expansion and contraction of the electrode active material with discharge and charge, electrical stability, and thermal stability.

In addition, if the electrode active material is not uniformly dispersed in the binder, the stress generated by the expansion and contraction of the electrode active material may be locally concentrated to cause electrode breakages such as peeling of the electrode layer from the electrode plate (foil). Therefore, the binder to serve as a constituent material of the electrode of the lithium ion battery requires a high adhesion force, and an ability to uniformly disperse the electrode active material. The polyimide resin composition according to the present invention is a material which is excellent in terms of heat resistance and electrically stable. In addition, the polyimide resin composition has a high force of adhesion to an inorganic base material, and easily disperses the electrode active material uniformly for the formation of stable varnish, so that an electrode can be formed which is less likely to be broken and excellent in terms of reliability.

In order to produce an electrode of a secondary battery such as a lithium ion battery with the use of the polyimide resin composition according to the present invention, first, an electrode active material such as particulate graphite or silicon and the polyimide resin composition to serve as a binder are mixed in the presence of an appropriate solvent to obtain electrode slurry. It is to be noted that the mixture ratio between the electrode active material and the polyimide resin composition is preferably the electrode active material/polyimide resin composition = 50/50 to 99/1 in terms of volume ratio, and further preferably 60/40 to 98/2. Then, the surface of metal foil such as copper foil or nickel foil is coated with the obtained electrode slurry in the form of a layer. Drying and, if necessary, press working can be carried out to obtain an electrode of a secondary battery such as a lithium ion battery.

In addition, the polyimide resin composition according to the present invention according to the present invention is used preferably as a protective film for metallic wire surfaces. In particular, the polyimide resin composition is used preferably as a protective film for metallic wires for use in coils such as motors.

In general, the protective film provided on the surface of metallic wires requires insulation performance and partial discharge endurance (low relative permittivity). In addition, in such a case as a metallic wire curved in order to produce a coil or the like, the protective film requires a certain level of softness so as not to peel from the metallic wire.

Polyamide-imide resins used commonly as a protective film provided on the surface of metallic wires have high softness, but have the problem of high relative permittivity. In addition, common polyimide resin compositions have low relative permittivity, but have low softness and adhesion. Therefore, protective films formed with the use of the polyimide resin compositions have a problem that when the metallic wires are curved, the protective films are likely to peel off from the surface of the metallic wires.

The polyimide resin composition according to the present invention has lower elative permittivity and higher heat resistance, as compared with the polyamide-imide resins. In addition, the polyimide resin composition according to the present invention is excellent in terms of adhesion and softness, as compared with conventional polyimide resin compositions. Therefore, the polyimide resin composition according to the present invention can, as a protective layer for metallic wires, increase the insulation performance and partial discharge endurance while maintaining the adhesion and softness.

In the case of using the polyimide resin composition according to the present invention as a protective film for the surface of metallic wires, the thickness of the protective film is typically 10 to 200 µm, and preferably 15 to 100 µm. The thickness of the protective film is less than 10 µm may lead to insufficient insulation performance and partial discharge endurance in some cases. On the other hand, the thickness of the protective film more than 200 µm may lead to insufficient softness in some cases.

The protective layer including the polyimide resin composition can be formed by, for example, applying the polyimide resin composition in the form of varnish to the surface of metallic wires, and then drying, and if necessary, firing the polyimide resin composition.

The polyimide resin composition according to the present invention can be used preferably as a binder resin for constituting a conductive adhesive layer for an electromagnetic-wave shielding film. A typical electromagnetic-wave shielding film includes a protective layer in the form of a film or a sheet, and a conductive adhesive layer placed on this protective layer. The conductive adhesive layer includes therein a conductive filler and a binder resin. Further, the conductive adhesive layer is formed on the protective layer by the conductive filler dispersed and immobilized in the binder resin.

The polyimide resin composition according to the present invention has a high adhesion force, and can be thus densely filled with the conductive filler. Therefore, an electromagnetic-wave shielding film can be formed which has high shielding performance. In addition, the polyimide resin composition according to the present invention has high softness, and thus has sufficient flexibility even when a thick conductive adhesive layer is formed. Therefore, the conductive adhesive layer is formed to be thick, so that the electromagnetic-wave shielding performance can be further increased while keeping the flexibility.

Examples of the conductive filler include, for example, flat metal powders such as silver and copper; flat metal-coated metal powders such as silver-coated copper powders; and metal-coated resin powders such as flat styrene particle cores coated with nickel (Ni) and gold (Au) flash plating. In addition, it is also possible to use such spherical conductive particles as used in anisotropic conductive adhesives. The average particle size of the conductive filler is not particularly limited, but preferably 2 to 20 µm, and further preferably 5 to 10 µm. It is to be noted that in the case of assuming that the shape of the conductive filler is flat and that the longest diameter is regarded as the particle size, the thickness of the conductive filler is preferably 5 to 40% of the longest diameter.

In order to produce an electromagnetic-wave shielding film with the use of the polyimide resin composition according to the present invention, for example, the polyimide resin composition and the conductive filler are mixed uniformly along with a solvent to prepare a varnish. The mixture ratio between the conductive filler and the polyimide resin composition is preferably the conductive filler/polyimide resin composition = 70/30 to 99/1, and further preferably 85/15 to 95/5 in terms of mass ratio. The prepared varnish is applied onto a resin film or the like to serve as the protective layer, and then dried, thereby making it possible to produce an electromagnetic-wave shielding film.

The polyimide resin composition according to the present invention can be used preferably as a binder resin for constituting a reflective material for an optical semiconductor. A typical reflective material for an optical semiconductor includes a light reflective filler and a binder resin. Further, the reflective material for an optical semiconductor is formed by the light reflective filler dispersed and immobilized in the binder resin. The polyimide resin composition according to the present invention has a high adhesion force, and can be thus densely filled with the light reflective filler. Therefore, a reflective material for an optical semiconductor can be formed which is able to be bonded reliably anywhere in a chassis or the like.

Examples of the light reflective filler include metal oxides such as titanium oxide, potassium titanate; inorganic glass, silica, and alumina; metal salts such as calcium carbonate, barium carbonate, calcium silicate, and nickel carbonate; and resins such as polystyrene resins, poly(meth)acrylate resins, and cross-linked resins thereof. It is to be noted that the light reflective filler preferably has hollow particles, and further preferably has hollow particles of 0.01 to 500 µm in outside diameter in terms of light reflectivity and handling.

In order to produce a reflective material for an optical semiconductor with the use of the polyimide resin composition according to the present invention, for example, the polyimide resin composition and the light reflective filler are mixed, and molded into a predetermined shape. The mixture ratio between the light reflective filler and the polyimide resin composition is preferably the light reflective filler/polyimide resin composition = 50/50 to 99/1, and further preferably 70/30 to 95/5 in terms of mass ratio. Then, curing by drying or the like can provide a reflective material for an optical semiconductor.

The polyimide resin composition according to the present invention can be used preferably as a binder resin for obtaining a conductive paste. A typical conductive paste includes conductive particles and a binder resin, and the conductive particles are dispersed in the binder resin. The polyimide resin composition according to the present invention has a high adhesion force, and the conductive particles can be thus densely dispersed. Therefore, a conductive paste can be provided which has a high electrical conductivity. In addition, the polyimide resin composition according to the present invention has high softness, and thus can effectively relax the stress generated between various types of parts and a substrate or the like when the polyimide resin composition is used as a constituent material of a "solder paste" for mounting the various types of parts on the substrate or the like.

While the type of the conductive particles is not particularly limited as long as the conductive particles are intended for use in common conductive pastes, solder particles are preferred which has a melting point of 80 to 240°C. While the composition of the solder particles is also not particularly limited, examples of the composition can include alloys of tin (Sn) as a base with a metal such as silver (Ag) and copper (Cu), and alloys of tin with a metal such as bismuth (Bi), zinc (Zn), and indium (In).

The conductive paste can be produced by mixing the polyimide resin composition with the conductive particles in accordance with a given method. The mixture ratio between the conductive particles and the polyimide resin composition is preferably the conductive particles/polyimide resin composition = 20/80 to 90/10, and further preferably 30/70 to 80/20 in terms of mass ratio.

The polyimide resin composition according to the present invention can be used preferably as a binder resin constituting a heat release material for releasing, to the outside, heat generated from a heat source such as an electronic device. A typical heat release material contains a heat release filler and a binder resin. Further, the heat release material is formed by the heat release filler dispersed and immobilized in the binder resin. The polyimide resin composition according to the present invention has a high adhesion force, and can be thus densely filled with the heat release filler. Therefore, a heat release material can be provided which has high heat release performance. In addition, the polyimide resin composition according to the present invention has high softness, and thus can effectively relax the stress generated between various types of parts and a substrate or the like when the polyimide resin composition is used to mount the obtained heat release material as a part.

While the type of the heat release filler is not particularly limited as long as the heat release filler is intended for use in common heat release materials, inorganic filling materials are preferable such as boron nitride, silicon nitride, aluminum nitride, alumina, aluminum oxide, silicon oxide, and magnesium oxide. Above all, inorganic filling materials are preferable which have a thermal conductivity of 20 W/m-K or more, and boron nitride, silicon nitride, aluminum nitride, and alumina are further preferable.

The heat release material can be produced by mixing the polyimide resin composition with the heat release filler in accordance with a given method. The mixture ratio between the heat release filler and the polyimide resin composition is preferably the heat release filler /polyimide resin composition = 25/75 to 85/15, and further preferably 35/65 to 75/25 in terms of mass ratio.

The polyimide resin composition according to the present invention is preferred as a constituent material of a foaming molding article for heat insulation. The insulation refers to a member used for protecting various types of electronic components from heat generated from a heat generation source such as, for example, a CPU. The polyimide resin composition according to the present invention has softness, and thus, even when the polyimide resin composition is molded into a foam, the obtained foaming molding article is less likely to be brittle, and a sufficient mechanical strength is maintained. In addition, the polyimide resin composition according to the present invention has advantages such as that it is easy for the polyimide resin composition to be molded into a foam, because of its sufficiently low glass transition temperature (Tg).

The foaming molding article can be produced by molding into a foam in accordance with a given method with the use of the polyimide resin composition. The polyimide resin composition is molded into the shape of a plate or sheet to obtain a molded article, for example, by a molding method such as injection molding or extrusion molding. The obtained molded article is impregnated with an inert gas at a predetermined temperature under pressure to relieve the pressure rapidly, and impart thermodynamic stability to the resin molded article impregnated with the inert gas, thereby forming a foaming nucleus.

Examples of the inert gas include argon, nitrogen, fluorine, and carbon dioxide. The impregnation temperature of the inert gas is preferably a temperature from 20°C to lower than the glass transition temperature (Tg). In addition, the impregnation temperature of the inert gas is preferably 5 to 30 MPa. The resin molded article with the foaming nucleus formed can be heated to produce a foam. The temperature of heating the resin molded article may be, for example, the glass transition temperature (Tg) of the polyimide resin composition to the glass transition temperature (Tg) - 70°C.

The polyimide resin composition according to the present invention can be used preferably as a binder resin (a binder for low dielectric material) for constituting an interlayer insulating film. The interlayer insulating film refers to a member provided so as to cover wirings in a multilayer wiring board. It is to be noted that the interlayer insulating film is required to have a low dielectric constant, because the interlayer insulating film is a member for electrically insulating wirings in the respective layers. A typical interlayer insulating film includes a low dielectric constant material and a binder for low dielectric material, and the low dielectric constant material is dispersed in the binder for low dielectric material.

The polyimide resin composition according to the present invention has a high adhesion force, and can be thus densely filled with the low dielectric constant material. Therefore, an interlayer insulating film can be produced which has a lower dielectric constant. In addition, the polyimide resin composition according to the present invention has high softness, and thus can effectively relax the stress generated between various types of parts and a substrate or the like when the interlayer insulating film obtained with the use of the polyimide resin composition is mounted as a part.

The types of the low dielectric constant material include, but not particularly limited as long as the low dielectric constant material is intended for use in common interlayer insulating films, molten silica, hollow silica, and the like. The interlayer insulating film can be produced by mixing the polyimide resin composition and the low dielectric constant material in accordance with a given method, and then molding the mixture in accordance with various types of molding methods. The mixture ratio between the low dielectric constant material and the polyimide resin composition is preferably the low dielectric constant material/polyimide resin composition = 20/80 to 70/30, and further preferably 30/70 to 60/40 in terms of mass ratio.

The polyimide resin composition according to the present invention can be used preferably as an adhesive agent for a planar heating element. Configuration examples of the planar heating element include (i) polyimide film/adhesive layer/SUS layer and (ii) aluminum layer/adhesive layer/SUS layer. In the configuration example (i), an electric current is applied through a circuit formed in the SUS layer to generate heat. In addition, in the configuration example (ii), an electric current is applied through a circuit formed in the SUS layer to generate heat, and the aluminum layer is allowed to function as a member for cooling. Applications of the planar heating elements which have these configurations include, for example, heaters of laser printer heads, preheating heater of in-car backlights, and far-infrared panel heaters. The polyimide resin composition according to the present invention has a high adhesion force, and excellent heat resistance. Therefore, the use of the polyimide resin composition according to the present invention as an adhesive agent for a planar heating element can provide a planar heating element including an adhesive layer which also exerts sufficient adhesion under hot temperature conditions.

In addition, the polyimide resin composition according to the present invention has thermoplasticity, and has an adequately low glass transition temperature (Tg). Therefore, when an adhesive layer is formed on a heating element, after curing is unnecessary, and low-temperature laminate is possible.

The planar heating element can be produced by, for example, applying the polyimide resin composition onto a predetermined area (the surface) of a heating element to form a coating layer, and then subjecting the coating layer drying by heating or the like to form an adhesive layer. It is to be noted that the polyimide resin composition may be mixed with a solvent, if necessary.

The polyimide resin composition according to the present invention can be used preferably as an adhesive agent (an adhesive agent for a coverlay film) for constituting an adhesive agent layer for a coverlay film. The coverlay film refers to a member used for protecting the surface of a flexible printed circuit (FPC). A typical coverlay film includes a polyimide film, and an adhesive agent layer placed on the polyimide film. It is to be noted that a mold release film or the like is placed on the adhesive agent layer, if necessary. The polyimide resin composition according to the present invention has an adhesion force, and has excellent heat resistance. Therefore, the use of the polyimide resin composition according to the present invention as an adhesive agent for a coverlay film can provide a coverlay film including an adhesive layer which also exerts sufficient adhesion under hot temperature conditions.

In addition, the polyimide resin composition according to the present invention has thermoplasticity, and has an adequately low glass transition temperature (Tg). Therefore, when an adhesive layer is formed on a polyimide film, after curing is unnecessary, and low-temperature laminate is possible. Furthermore, the polyimide resin composition according to the present invention has high softness, and thus can improve the bendability of a flexible printed circuit (FPC).

The coverlay film can be produced by, for example, applying the polyimide resin composition onto a polyimide film to form a coating layer, and then subjecting the coating layer drying by heating or the like to form an adhesive layer. It is to be noted that the polyimide resin composition may be mixed with a solvent, if necessary.

The polyimide resin composition according to the present invention can be used preferably as a primer or a modifying material for a pre-coated metal (PCM) paint. The primer for the PCM paint is a component applied in advance on the surface of a steel plate to which the PCM paint is to be applied. In addition, the modifying material for the PCM paint is a component added to the PCM paint. Each of the primer and modifying material improves the adhesion of the coating film to the surface of the steel plate, or provide the coating film with softness.

The polyimide resin composition according to the present invention has high adhesion, and thus improves the peeling strength of a coating film formed on a steel plate, when the polyimide resin composition is used as the primer or modifying material for the PCM paint. In addition, the polyimide adhesive agent according to the present invention has high softness, and thus makes it less likely that a coating film formed on a steel plate has a crack caused, when the polyimide adhesive agent is used as the primer or modifying material for the PCM paint. Furthermore, drying at low temperature becomes possible, thus improving the productivity of pre-coated metal (a steel plate with a coating film formed).

The polyimide resin composition according to the present invention can be used preferably as a liquid sealing material for a semiconductor, or a modifying material thereof. The polyimide resin composition according to the present invention has high softness, and can thus prevent a semiconductor element to be sealed from having defects such as cracking caused due to stress relaxation, when the polyimide resin composition is used as a liquid sealing material for a semiconductor, or a modifying material thereof. In particular, the polyimide resin composition is effective for preventing cracking of semiconductor elements (chips) which have been thinner and thinner in recent years.

In addition, the polyimide resin composition according to the present invention allows low-temperature drying, and can be mixed with other resin components such as an epoxy resin. Therefore, when the polyimide resin composition is used as a liquid sealing material for a semiconductor, or a modifying material thereof, a B-stage molded article (sealed body) can be achieved by drying in a low temperature range to the extent that the epoxy resin or the like is not cured, and thereby removing the solvent.

### EXAMPLES

The abbreviations of compounds used in examples and comparative examples will be shown below.
(A) Aromatic Diamine
   APB: 1,3-bis(3-aminophenoxy)benzene (manufactured by Mitsui Chemicals, Inc.)
(B) Silicone Diamine
   1-Si: 1,3-bis(3-aminopropyl)tetramethyldisiloxane
(C) Aliphatic Diamine
   14EL: polytetramethylene oxide di-p-aminobenzoate (Product Name: Elastomer 1000, manufactured by Ihara Chemical Industry Co., Ltd.)
   XTJ-542: polyetheramine represented by the following formula (Product Name: JEFFAMINE, manufactured by Huntsuman Co., Ltd.) 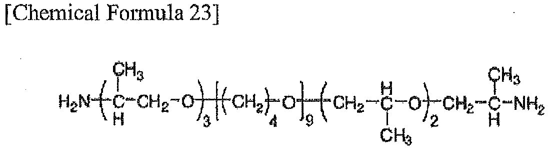
(D) Aromatic Tetracarboxylic Dianhydride
   s-BPDA: 3,3',4,4'-biphenyl tetracarboxylic dianhydride (manufactured by JFE Chemical Corporation)
   PMDA: pyromellitic dianhydride

### [Example 1]

### Preparation of Polyimide Varnish

Four types of diamines (APB, 1-Si, 14EL, XTJ-542) and one type of acid dianhydride (s-BPDA) were blended with a molar ratio of APB : 1-Si : 14EL : XTJ-542 : s-BPDA = 0.49 : 0.1 : 0.2 : 0.21 : 1.0, in a solvent of NMP and mesitylene adjusted to have a ratio of 7/3. The obtained mixture was stirred for four or more hours in a flask into which a dry nitrogen gas was able to be introduced, thereby providing a polyamic acid solution with a resin solid content weight of 20 to 25 weight%. After sufficient stirring, the reaction system was heated to approximately 180°C while stirring in a flask with a Dean-Stark tube, and water produced by a dehydration reaction was taken outside the system to obtain a polyimide varnish. The viscosity of the obtained polyimide varnish was 8.0 × 10³ mPa·s, which was measured by an E-type viscometer at 25°C.

### Preparation of Film

The obtained varnish solution was applied at a rate of 10 mm/sec onto a PET film subjected to a mold release treatment. The obtained coating film was dried at 160°C for 1 hour to remove the solvent. After the drying, the film portion was peeled from the PET film with the use of tweezers or the like to prepare a polyimide film (film thickness: 60 µm).

### [Example 2]

A polyimide varnish was prepared in a manner similar to Example 1, except that the four types of diamines (APB, 1-Si, 14EL, XTJ-542) and the acid dianhydride (s-BPDA) were blended with a molar ratio of APB : 1-Si : 14EL : XTJ-542 : s-BPDA = 0.29 : 0.3 : 0.2 : 0.21 : 1.0, a polyimide varnish. The viscosity of the obtained polyimide varnish was 5.0 × 10³ mPa·s, which was measured by an E-type viscometer at 25°C. From the obtained polyimide varnish, a polyimide film was prepared in a manner similar to Example 1.

### [Example 3]

1-Si as a diamine component and s-BPDA as an acid dianhydride component were blended with a molar ratio of 1-Si : s-BPDA = 0.1 : 1.0, in a solvent of NMP and mesitylene adjusted to have a ratio of 7/3. The obtained mixture was stirred for four or more hours in a flask into which a dry nitrogen gas was able to be introduced, thereby providing a polyamic acid solution with a resin solid content weight of 20 to 25 weight%. After sufficient stirring, the reaction system was heated to approximately 180°C while stirring in a flask with a Dean-Stark tube, and water produced by a dehydration reaction was taken outside the system to obtain a polyimide varnish (A).

To the obtained polyimide varnish (A), three types of diamines (APB, 14EL, XTJ-542) as diamine components were added so that the final monomer ratio was APB : 1-Si : 14EL : XTJ-542 : s-BPDA = 0.49 : 0.1 : 0.2 : 0.21 : 1.0 in terms of molar ratio. The obtained mixture was stirred for one or more hours in a flask into which a dry nitrogen gas was able to be introduced. Then, the reaction system was heated to on the order of 180°C while stirring in a flask with a Dean-Stark tube, and water produced by a dehydration reaction was taken outside the system to obtain a polyimide varnish (B) with an imide block of 1-Si/s-BPDA introduced into molecules of the polyimide. The viscosity of the obtained polyimide varnish (B) was 8.0 × 10³ mPa·s, which was measured by an E-type viscometer at 25°C. From the obtained polyimide varnish (B), a polyimide film was prepared in a manner similar to Example 1.

### [Examples 4 to 8]

Except that the types of diamines and acid anhydride shown in Table 1 were blended in additive amounts (molar ratios) shown in Table 1, polyimide varnishes (B) were prepared in the same way as in the case of Example 1. The viscosities of the obtained polyimide varnishes (B) were respectively 10 × 10³ mPa·s (Example 4), 11 × 10³ mPa·s (Example 5), 15 × 10³ mPa·s (Example 6), 9.0 × 10³ mPa·s (Example 7), and 8.0 × 10³ mPa·s (Example 8), which were measured by an E-type viscometer at 25°C. From the obtained polyimide varnishes (B), polyimide films were prepared in the same way as in the case of Example 1.

### [Comparative Example 1]

A polyimide varnish was prepared in a manner similar to Example 1, except that one type of diamine (APB) and one type of acid dianhydride (s-BPDA) were blended with a molar ratio of APB : s-BPDA = 1.0 : 1.0. The viscosity of the obtained polyimide varnish was 4.0 × 10³ mPa·s, which was measured by an E-type viscometer at 25°C. From the obtained polyimide varnish, a polyimide film was prepared in a manner similar to Example 1.

### [Comparative Example 2]

A polyimide varnish was prepared in a manner similar to Example 1, except that one type of diamine (14EL) and one type of acid dianhydride (PMDA) were blended with a molar ratio of 14EL : PMDA = 1.0 : 1.0. The viscosity of the obtained polyimide varnish was 4.0 × 10³ mPa•s, which was measured by an E-type viscometer at 25°C. From the obtained polyimide varnish, a polyimide film was prepared in a manner similar to Example 1.

### [Comparative Example 3]

A polyimide varnish was prepared in a manner similar to Example 1, except that three types of diamines (APB, 14EL, XTJ-542) and one type of acid dianhydride (s-BPDA) were blended with a molar ratio of APB : 14EL : XTJ-542 : s-BPDA = 0.8 : 0.1 : 0.1 : 1.0. The viscosity of the obtained polyimide varnish was 5.0 × 10³ mPa•s, which was measured by an E-type viscometer at 25°C. From the obtained polyimide varnish, a polyimide film was prepared in a manner similar to Example 1.

### [Comparative Examples 4 to 7]

Polyimide varnishes were prepared in a manner similar to Example 1, except that the types of diamines and acid anhydride shown in Table 2 were blended in additive amounts (molar ratios) shown in Table 1. The viscosities of the obtained polyimide varnishes were respectively 5.0 × 10³ mPa•s (Comparative Example 4), 8.0 × 10³ mPa•s (Comparative Example 5), 5.0 × 10³ mPa•s (Comparative Example 6), and 3.0 × 10³ mPa•s (Example 7), which were measured by an E-type viscometer at 25°C. From the obtained polyimide varnishes, polyimide films were prepared in a manner similar to Example 1.

The stability of the polyimide varnishes obtained in Examples 1 to 8 and Comparative Examples 1 to 7, and the adhesion, glass transition temperature, melt viscoelasticity, and thermal decomposition temperature for polyimide films were measured in the following ways. These results are shown in Tables 1 and 2.

### 1. Varnish Stability

The prepared polyimide varnishes were collected in transparent small bottles, and stored in refrigerator (3°C). In this case, whether or not resin precipitation or gelation was caused was confirmed by observing changes with time in the appearances of the polyimide varnishes in the small bottles.
After starting to store the polyimide varnishes under the condition mentioned above, the polyimide varnish was evaluated as "o" if no gel was produced for two or more months, evaluated as "Δ" if a gel was produced after 24 hours before two months, and evaluated as "x" if a gel was produced within 24 hours.

### 2. Adhesion

The prepared polyimide varnishes were applied by a dip coating method onto mirrored silicon substrates cut in a predetermined size, and dried at 160°C for one hour. In the thus obtained silicon substrates covered with the thin coating films of the polyimide varnishes, cuts were made from the other surfaces (reverse sides) rather than the sides (mirrored sides) with the polyimide varnishes applied, and the silicon substrates were divided into two parts (without dividing the coating films of the polyimide varnishes). For the silicon substrates (with the coating films), obtained by the divide, the force for pulling up and peeling the coating film in a direction at 180 degrees with the divided side as a base point was measured by Strograph-M1manufactured by Toyo Seiki Co., Ltd. This measurement evaluated the adhesion of the coating film of the polyimide varnish to the silicon substrate.
The adhesion was evaluated as "o" if the force required for peeling of the coating film was 20 N/cm or more, evaluated as "Δ" if the force was 15 N/cm or more and less than 20 N/cm, and evaluated as "×" if the force was less than 15 N/cm.

### 3. Glass Transition Temperature

The storage elastic modulus E' and loss elastic modulus E" were measured for the prepared polyimide films in accordance with the temperature dispersion measurement (tensile mode) of solid viscoelasticity. The glass transition temperatures of the films were calculated from the peak value of the obtained loss tangent tan δ = E"/E'.

### 4. Thermal Decomposition Temperature (Heat Resistance)

The thermal decomposition temperatures of the prepared polyimide films were measured by TGA-51 from Shimadzu Corporation. A predetermined amount of polyimide sample was weighed in a quartz crucible as an attachment of the TGA-51, and set up on a balance of the apparatus. Then, the thermolytic behavior (decrease in weight) was measured from room temperature up to 800°C under an air atmosphere and under a nitrogen atmosphere. The heating temperature at which the initial sample weight was decreased by 5 weight% was regarded as the thermal decomposition temperature (the decrease by 5 weight%).

### 5. Film Transparency

The transparency was evaluated by visually observing polyimide films prepared to have a thickness on the order of 50 µm. The transparency was evaluated as "o" if the opposite side was able to be seen without being clouded, and as "Δ" if the opposite side was seen cloudy while being clouded.

**[Table 1]**

| | | | Example 1 | Example 2 | Example 3 | Example 4 | Example 5 | Example 6 | Example 7 | Example 8 |
|---|---|---|---|---|---|---|---|---|---|---|
| Composition | Aromatic Diamine (A) | Type | APB | APB | APB | APB | APB | APB | APB | APB |
| | | Additive Amount (Molar Ratio) | 0.49 | 0.29 | 0.49 | 0.6 | 0.6 | 0.7 | 0.5 | 0.4 |
| | Silicone Diamine (B) | Type | 1-Si | 1-Si | 1-Si | 1-Si | 1-Si | 1-Si | 1-Si | 1-Si |
| | | Additive Amount (Molar Ratio) | 0.1 | 0.3 | 0.1 | 0.1 | 0.1 | 0.1 | 0.05 | 0.1 |
| | Aliphatic Diamine (C) | Type | 14EL | 14EL | 14EL | 14EL | 14EL | 14EL | 14EL | 14EL |
| | | Additive Amount (Molar Ratio) | 0.2 | 0.2 | 0.2 | 0.1 | 0.2 | 0.1 | 0.2 | 0.25 |
| | | Type | XTJ-542 | XTJ-542 | XTJ-542 | XTJ-542 | XTJ-542 | XTJ-542 | XTJ-542 | XTJ-542 |
| | | Additive Amount (Molar Ratio) | 0.21 | 0.21 | 0.21 | 0.2 | 0.1 | 0.1 | 0.25 | 0.25 |
| | Aromatic Tetracarboxylic Dianhydride (D) | Type | s-BPDA | s-BPDA | s-BPDA | s-BPDA | s-BPDA | s-BPDA | s-BPDA | s-BPDA |
| | | Additive Amount (Molar Ratio) | 1 | 1 | 1 | 1 | 1 | 1 | 1 | 1 |
| (A+B)/(A+B+C+D)(Molar Ratio) | | | 0.295 | 0.295 | 0.295 | 0.35 | 0.35 | 0.4 | 0.275 | 0.25 |
| (A+B+C)/D (Molar Ratio) | | | 1 | 1 | 1 | 1 | 1 | 1 | 1 | 1 |
| Polymerization of Silicone Diamine (B) | | | Random | Random | Block | Block | Block | Block | Block | Block |
| Evaluation | Varnish Stability | | ○ | ○ | ○ | ○ | ○ | ○ | ○ | ○ |
| | Adhesion | | ○ | ○ | ○ | ○ | ○ | ○ | Δ to ○ | ○ |
| | Glass Transition Temperature (°C) | | 75 | 55 | 75 | 97 | 97 | 130 | 64 | 54 |
| | Thennal Decomposition Temperature (°C) | | 370 | 390 | 390 | 390 | 400 | 402 | 355 | 380 |
| | Film Transparency | | ○ | Δ | ○ | ○ | ○ | ○ | ○ | ○ |

**[Table 2]**

| | | | Comparative Example 1 | Comparative Example 2 | Comparative Example 3 | Comparative Example 4 | Comparative Example 5 | Comparative Example 6 | Comparative Example 7 |
|---|---|---|---|---|---|---|---|---|---|
| Composition | Aromatic Diamine (A) | Type | APB | - | APB | APB | - | - | - |
| | | Additive Amount (Molar Ratio) | 1 | - | 0.8 | 0.5 | - | - | - |
| | Silicone Diamine (B) | Type | - | - | - | 1-Si | 1-Si | 1-Si | 1-Si |
| | | Additive Amount (Molar Ratio) | - | - | - | 0.5 | 0.1 | 0.1 | 1 |
| | Aliphatic Diamine (C) | Type | - | 14EL | 14EL | - | 14EL | 14EL | - |
| | | Additive Amount (Molar Ratio) | - | 1 | 0.1 | - | 0.45 | 0.45 | - |
| | | Type | - | - | XTJ-542 | - | XTJ-542 | XTJ-542 | - |
| | | Additive Amount (Molar Ratio) | - | - | 0.1 | - | 0.45 | 0.45 | - |
| | Aromatic Tetracarboxylic Dianhydride (D) | Type | s-BPDA | PMDA | s-BPDA | s-BPDA | s-BPDA | s-BPDA | s-BPDA |
| | | Additive Amount (Molar Ratio) | 1 | 1 | 1 | 1 | 1 | 1 | 1 |
| (A+B)/(A+B+C+D) (Molar Ratio) | | | - | - | - | - | - | - | - |
| (A+B+C)/D (Molar Ratio) | | | - | - | - | - | - | - | - |
| Polymerization of Silicone Diamine (B) | | | - | - | - | Random | Random | Block | - |
| Evaluation | Varnish Stability | | Δ | × | ○ | × to Δ | ○ | ○ | × to Δ |
| | Adhesion | | × (10N/cm) | - | Δ (18N/cm) | - | Δ | Δ | - |
| | Glass Transition Temperature (°C) Thermal Decomposition Temperature (°C) | | 200 | - | 150 | - | -39 | -38 | - |
| | | | 550 | - | 330 | - | 330 | 340 | - |
| | Film Transparency | | ○ | - | ○ | - | Δ | ○ | - |

As shown in Table 1, the polyimide films obtained in Examples 1 to 8 each have a low glass transition temperature, and thus excellent adhesion to the silicon substrate, and also has a thermal decomposition temperature of 355°C or more, and thus excellent heat resistance. In addition, the polyimides obtained in Examples 1 to 8 have favorable varnish stability.

On the other hand, as shown in Table 2, it is determined that the polyimide obtained in Comparative Example has a high thermal decomposition temperature, and thus excellent heat resistance, but has low varnish stability and also low adhesion to the silicon substrate. This is considered to be because the polyimide obtained in Comparative Example 1 contains no silicone diamine (B) or aliphatic diamine (C), and thus has low softness. In the case of Comparative Example 2, it is determined that the varnish is turned into a gel. This is considered to be because the polyimide containing the aliphatic diamine (C) has relatively high reactivity. In the case of Comparative Example 3, it is determined that the adhesion is low because of containing no silicone diamine (B), and furthermore, the thermal decomposition temperature is low because the aliphatic diamine (C) tends to be thermally decomposed.

It is determined that the polyimide films obtained in Comparative Examples 4 and 7 have low varnish stability. This is considered to be because the polyimides obtained in Comparative Examples 4 and 7 contain no aliphatic diamine (C). In addition, it is determined that the polyimide films obtained in Comparative Examples 5 and 6 have low adhesion to the silicon substrate, and low thermal decomposition temperatures. This is considered to be because the polyimides obtained in Comparative Examples 5 and 6 contain no aromatic diamine (A).

In addition, it is determined that the polyimide film according to Example 3 with the silicone diamine introduced as a block structure has a 20°C higher thermal decomposition temperature in spite of the comparable glass transition temperature, as compared with the polyimide film according to Example 1 with the silicone diamine introduced randomly. This is estimated to be because when the imide block including the silicone diamine was sandwiched by the imide block including the other diamine, cyclic siloxane was able to be prevented from being produced from the silicone diamine, or because of a small amount of unreacted silicone diamine.

It is determined that the polyimide film obtained in Example 3, as compared with the polyimide film obtained in Example 7. This is estimated to be because the ratio of the silicone diamine (B) contained in the polyimide obtained in Example 3 falls within a more appropriate range, as compared with the ratio of the silicone diamine (B) contained in the polyimide obtained in Example 7. In addition, it is determined that the polyimide film obtained in Example 1 is excellent in terms of transparency, as compared with the polyimide film obtained in Example 2. This is estimated to be because the ratio of the silicone diamine (B) contained in the polyimide obtained in Example 1 falls within a more appropriate range, as compared with the ratio of the silicone diamine (B) contained in the polyimide obtained in Example 2.

The present application claims the priority based on the application number JP2010-013201 filed on January 25, 2010, the application number JP2010-151165 filed on July 1, 2010, and the application number JP2010-213806 filed on September 24, 2010. The content in the specifications of the applications are all incorporated therein.

### INDUSTRIAL APPLICABILITY

The polyimide resin composition according to the present invention can be used widely as an adhesive material between a semiconductor chip and other semiconductor chip or a substrate, a protective material for a circuit of a semiconductor chip, or an interlayer insulating material. In particular, the polyimide resin composition according to the present invention is excellent in terms of heat resistance, and thus used preferably, in particular, in an adhesive material, a protective material, or an insulating material for a device including a semiconductor chip which produce a lot of heat.

### DESCRIPTION OF REFERENCE SIGNS

- 10, 10', 10": device
- 12, 12', 22, 32, 42: semiconductor chip
- 12A: terminal (of semiconductor chip)
- 13: underfill layer
- 14: polyimide resin composition layer
- 15,25: lead
- 16, 26, 36: substrate
- 17,27,37: bump
- 18, 28: film substrate
- 19: wire
- 24, 34: sealing layer
- 26A: recessed portion
- 50: solder resist
- 55: Al pad
- 60: bump base metal layer
- 65: Cu post
- 70: BGA package
- 80: COF package
- 90: package

## Claims

1. A polyimide resin composition comprising a polyimide obtained by condensation of:
a diamine component containing an aromatic diamine (A) represented by any of the following general formula (1-1) to (1-3), a silicone diamine (B) represented by the following general formula (2), and an aliphatic diamine (C) represented by the following general formula (3); and
an acid anhydride component containing an aromatic tetracarboxylic dianhydride (D) represented by the following general formula (4). 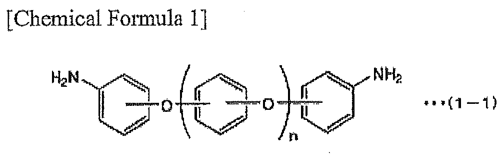
(In the general formula (1-1), n represents an integer of 1 to 20.) 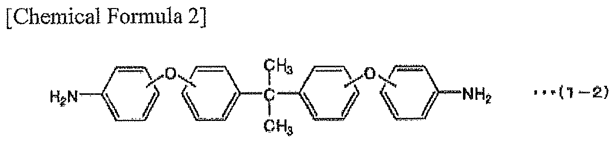 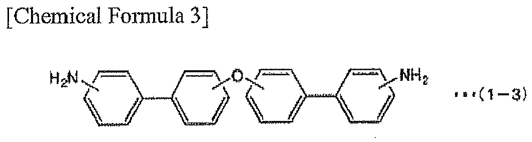 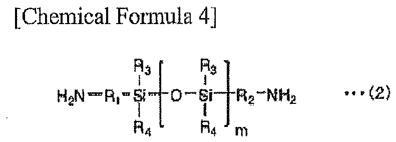
(In the general formula (2), R₁ and R₂ each independently represents a divalent aliphatic group having 1 to 5 carbon atoms or a divalent aromatic group having 6 or more carbon atoms, R₃ and R₄ each independently represents a monovalent aliphatic group having 1 to 5 carbon atoms or a monovalent aromatic group having 6 or more carbon atoms, and m represents an integer of 1 or more.) 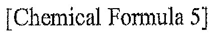 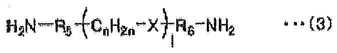
(In the general formula (3), R₅ and R₆ each independently represents an organic group including at least one selected from a group consisting of a carbonyl group, an oxycarbonyl group, an aromatic group having 6 or more carbon atoms, and an aliphatic group having one or more carbon atoms. X represents -O-, -S-, -NH-, -ONH-, or -OS-, 1 represents an integer of 1 to 50, and n represents an integer of 1 or more.) 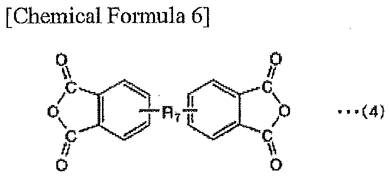
(In the general formula (4), R₇ represents a single bond, -O-, or a carbonyl group.)

2. The polyimide resin composition according to claim 1, wherein
the aromatic diamine (A) is represented by the following general formula (1),
wherein the aliphatic diamine (C) is represented by the following general formula (3-1), and
wherein the aromatic tetracarboxylic dianhydride (D) is represented by the following general formula (4-1). 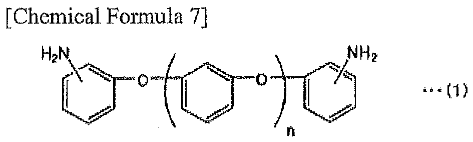 (In the general formula (1), n represents an integer of 1 to 20.) 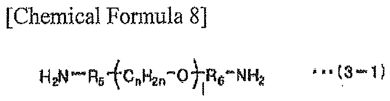 (In the general formula (3-1), R₅ and R₆ each independently represents an organic group including at least one selected from a group consisting of a carbonyl group, an oxycarbonyl group, an aromatic group having 6 or more carbon atoms, and an aliphatic group having one or more carbon atoms, 1 represents an integer of 1 to 50, and n represents an integer of 1 or more.) 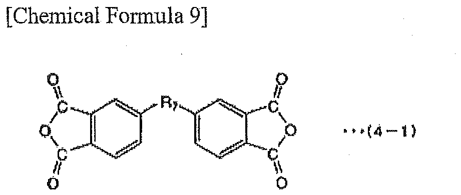 (In the general formula (4-1), R₇ represents a single bond, -O-, or a carbonyl group.)

3. The polyimide resin composition according to claim 1, wherein
the aliphatic diamine (C) is a diamine represented by the following general formula (3a), or a diamine represented by the following general formula (3b). 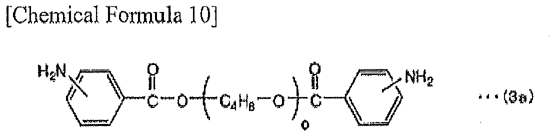 (In the general formula (3a), o represents an integer of 1 to 50.) 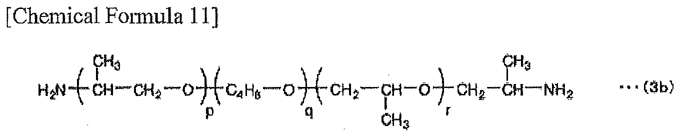 (In the general formula (3b), p, q, and r each independently represent an integer of 0 to 10.)

4. The polyimide resin composition according to claim 1, wherein
the polyimide is a block copolymer includes:
an imide block b1 obtained from the silicone diamine (B) and the aromatic tetracarboxylic dianhydride (D); and
an imide block b2 obtained from the aromatic diamine (A), the aliphatic diamine (C), and the aromatic tetracarboxylic dianhydride (D), the imide block (2) introduced at either end of the imide block b1.

5. The polyimide resin composition according to claim 1, wherein
the polyimide is obtained through the steps of:
obtaining an oligomer by polycondensation of the silicone diamine (B) and the aromatic tetracarboxylic dianhydride (D) of more than 1 mol per mol of the silicone diamine (B); and
subjecting the oligomer to further polycondensation with the aromatic diamine (A) and the aliphatic diamine (C).

6. The polyimide resin composition according to claim 1, wherein
the ratio of the total number of moles of the aromatic diamine (A) and the silicone diamine (B) is 0.01 to 0.6 to the total number of moles of the diamine and aromatic tetracarboxylic dianhydride constituting the polyimide.

7. The polyimide resin composition according to claim 1, wherein
the composition has a glass transition temperature of 40 to 150°C, and a thermal decomposition temperature of 350°C or more.

8. The polyimide resin composition according to claim 1, further comprising an inorganic filler.

9. The polyimide resin composition according to claim 1, further comprising one or more compounds selected from a group consisting of epoxy compounds, acrylate compounds, isocyanate compounds, maleimide compounds, and nadimide compounds.

10. The polyimide resin composition according to claim 1, further comprising a polar solvent.

11. An adhesive agent comprising the polyimide resin composition according to claim 1.

12. A laminate comprising:
a base material; and
a resin layer comprising the polyimide resin composition according to claim 1, the resin layer placed on the base material.

13. A laminate comprising:
a base material; and
a resin layer placed on the base material, wherein
the resin layer is formed by drying, at a temperature of 190°C or less, a coating layer comprising the polyimide resin composition according to claim 10 applied on the base material.

14. The laminate according to claim 12, wherein
the polyimide resin composition has a glass transition temperature of 40 to 150°C; and
the base material is silicon, or a polyimide that has an elastic modulus of 1 GPa or more at room temperature and has a glass transition temperature of 240 to 440°C.

15. A device comprising;
a semiconductor element; and
a resin layer obtained from the polyimide resin composition according to claim 1, the resin layer placed on a surface of the semiconductor element.

## Amended claims

### Amended claims in accordance with Rule 137(2) EPC.

1. A polyimide resin composition comprising a polyimide obtained by condensation of:
a diamine component containing an aromatic diamine (A) represented by any of the following general formula (1-1) to (1-3), a silicone diamine (B) represented by the following general formula (2), and an aliphatic diamine (C) represented by the following general formula (3); and
an acid anhydride component containing an aromatic tetracarboxylic dianhydride (D) represented by the following general formula (4). 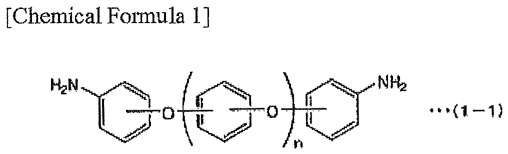
(In the general formula (1-1), n represents an integer of 1 to 20.) 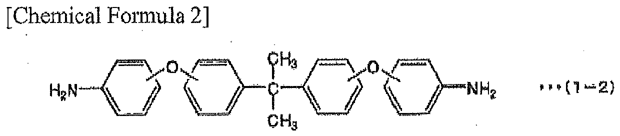 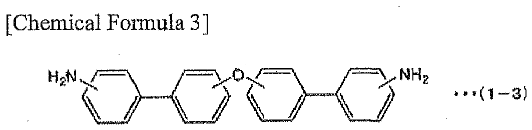 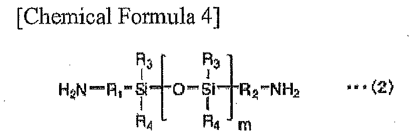
(In the general formula (2), R₁ and R₂ each independently represents a divalent aliphatic group having 1 to 5 carbon atoms or a divalent aromatic group having 6 or more carbon atoms, R₃ and R₄ each independently represents a monovalent aliphatic group having 1 to 5 carbon atoms or a monovalent aromatic group having 6 or more carbon atoms, and m represents an integer of 1 or more.) 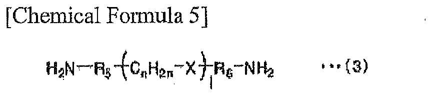
(In the general formula (3), R₅ and R₆ each independently represents an organic group including at least one selected from a group consisting of a carbonyl group, an oxycarbonyl group, an aromatic group having 6 or more carbon atoms, and an aliphatic group having one or more carbon atoms. X represents -O-, -S-, -NH-, -ONH-, or -OS-, 1 represents an integer of 1 to 50, and n represents an integer of 1 or more.) 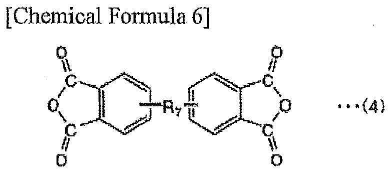
(In the general formula (4), R₇ represents a single bond, -O-, or a carbonyl group.)

2. The polyimide resin composition according to claim 1, wherein
the aromatic diamine (A) is represented by the following general formula (1),
wherein the aliphatic diamine (C) is represented by the following general formula (3-1), and
wherein the aromatic tetracarboxylic dianhydride (D) is represented by the following general formula (4-1). 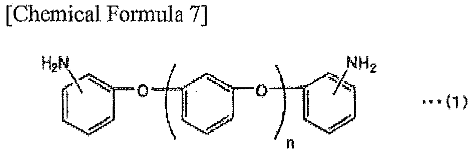 (In the general formula (1), n represents an integer of 1 to 20.) 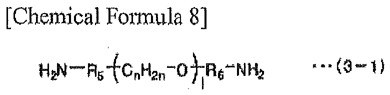 (In the general formula (3-1), R₅ and R₆ each independently represents an organic group including at least one selected from a group consisting of a carbonyl group, an oxycarbonyl group, an aromatic group having 6 or more carbon atoms, and an aliphatic group having one or more carbon atoms, 1 represents an integer of 1 to 50, and n represents an integer of 1 or more.) 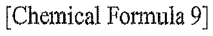 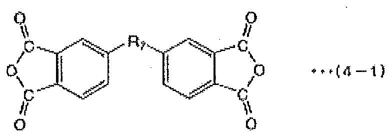 (In the general formula (4-1), R₇ represents a single bond, -O-, or a carbonyl group.)

3. (Amended) The polyimide resin composition according to claim 1, wherein
the aliphatic diamine (C) is a diamine represented by the following general formula (3 a), or a diamine represented by the following general formula (3b). 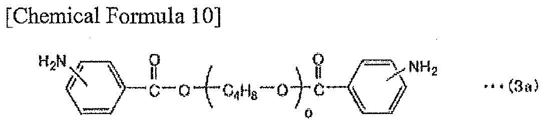 (In the general formula (3a), o represents an integer of 1 to 50.) 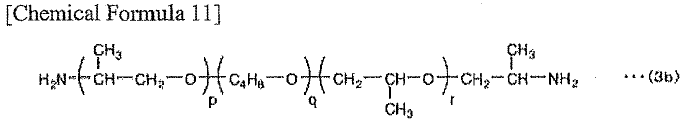 (In the general formula (3b), p, q, and r each independently represent an integer of 0 to 10, **and the sum of p, q, and r is 1 or more.)**

4. The polyimide resin composition according to claim 1, wherein
the polyimide is a block copolymer includes:
an imide block b1 obtained from the silicone diamine (B) and the aromatic tetracarboxylic dianhydride (D); and
an imide block b2 obtained from the aromatic diamine (A), the aliphatic diamine (C), and the aromatic tetracarboxylic dianhydride (D), the imide block (2) introduced at either end of the imide block b1.

5. The polyimide resin composition according to claim 1, wherein
the polyimide is obtained through the steps of:
obtaining an oligomer by polycondensation of the silicone diamine (B) and the aromatic tetracarboxylic dianhydride (D) of more than 1 mol per mol of the silicone diamine (B); and
subjecting the oligomer to further polycondensation with the aromatic diamine (A) and the aliphatic diamine (C).

6. The polyimide resin composition according to claim 1, wherein
the ratio of the total number of moles of the aromatic diamine (A) and the silicone diamine (B) is 0.01 to 0.6 to the total number of moles of the diamines and aromatic tetracarboxylic dianhydride constituting the polyimide.

7. The polyimide resin composition according to claim 1, wherein
the composition has a glass transition temperature of 40 to 150°C, and a thermal decomposition temperature of 350°C or more.

8. The polyimide resin composition according to claim 1, further comprising an inorganic filler.

9. The polyimide resin composition according to claim 1, further comprising one or more compounds selected from a group consisting of epoxy compounds, acrylate compounds, isocyanate compounds, maleimide compounds, and nadimide compounds.

10. The polyimide resin composition according to claim 1, further comprising a polar solvent.

11. An adhesive agent comprising the polyimide resin composition according to claim 1.

12. A laminate comprising:
a base material; and
a resin layer comprising the polyimide resin composition according to claim 1, the resin layer placed on the base material.

13. A laminate comprising:
a base material; and
a resin layer placed on the base material, wherein
the resin layer is formed by drying, at a temperature of 190°C or less, a coating layer comprising the polyimide resin composition according to claim 10 applied on the base material.

14. The laminate according to claim 12, wherein
the polyimide resin composition has a glass transition temperature of 40 to 150°C; and
the base material is silicon, or a polyimide that has an elastic modulus of 1 GPa or more at room temperature and has a glass transition temperature of 240 to 440°C.

15. A device comprising;
a semiconductor element; and
a resin layer obtained from the polyimide resin composition according to claim 1, the resin layer placed on a surface of the semiconductor element.
